# EUROPEAN PATENT APPLICATION

(11) **EP 2 322 738 A1**
(43) Date of publication of application: **18.05.2011**
(21) Application number: 09813030.5
(22) Date of filing: 02.09.2009
(51) Int. Cl.: E04D 13/18, E04D 1/30, E04D 3/40, H01L 31/042

(54) **SOLAR CELL MODULE AND SOLAR CELL ARRAY**

(30) Priority: 10.09.2008 JP 2008232221; 10.09.2008 JP 2008232223; 16.09.2008 JP 2008236527; 30.09.2008 JP 2008253483
(71) Applicant: Kaneka Corporation, Osaka-shi, Osaka 530-8288 (JP)
(72) Inventor: UEDA, Yasuhiro, Osaka-shi Osaka 530-8288 (JP); YAMAWAKI, Takeharu, Moriyama-shi Shiga 524-0102 (JP); ISHIDA, Kensuke, Osaka-shi Osaka 530-8288 (JP); NAKAJIMA, Takeharu, Ibaraki-shi Osaka 567-0894 (JP); OBAYASHI, Tadashi, Osaka-shi Osaka 530-8288 (JP)
(74) Representative: TBK
(86) International application number: PCT/JP2009/065368
(87) International publication number: WO 2010/029884

(57) **Abstract**

It is an object to provide a solar cell module having a uniform configuration, presenting stable output characteristics, and having a size enabling easy wiring in arrangement and a solar cell array presenting stable output characteristics by employment of said solar cell modules.

A solar cell module 10 has a solar cell panel 12 having a length of its longer edges of 900 to 1100 mm. The solar cell panel 12 is constituted by a number of unit solar cells 100 connected in series and has an open-circuit voltage of 100 to 180 volts. The unit solar cell 100 is of a strip-like shape with a length of its shorter edges of 7 to 12 mm and arranged in a longer-edge direction of the panel 12 so that its longer edges extend in a shorter-edge direction of the panel 12 and its shorter edges extend in the longer-edge direction of the panel 12.

## Description

### TECHNICAL FIELD

The present invention relates to a solar cell module for constituting a solar cell array arranged on a house and to a solar cell array constituted by the solar cell modules.

### BACKGROUND ART

Recently, a photovoltaic system with solar cell modules having solar cell panels arranged on a place such as a roof of a house has increased for covering electricity consumed at the house and simultaneously selling surplus electricity to an electric power company. A solar cell panel is an integrated solar cell, which is formed by laminating a film such as a conducting film and a semiconductor film on a glass substrate, cutting a plurality of grooves on the laminated layer so as to form a predetermined number of one-cell batteries (unit solar cells), and electrically connecting the unit solar cells in series. It is known that some panels generate a voltage of 100 volts or more. The Patent Document 1 specified below discloses a method for manufacturing such a solar cell panel.

The solar cell module as described above can generate a desired voltage by adjusting the number of serially-connected unit solar cells. However, in view of convenience of arrangement or manufacture, there is a limit to a size of the module and also some limits to the number of and an output voltage of the unit solar cells being connectable in series in the sole module. Further, the sole module can generate much less large output current. Thus, in the conventional art, a plurality of solar cell modules are electrically connected in parallel so as to form a solar cell block, a plurality of which are connected in series so as to form a solar cell array, and whereby an output voltage and an output current are adjusted to be a practical level.

As described above, when the solar cell modules are electrically connected in parallel so as to form the solar cell block and the solar cell array is constituted by the solar cell blocks formed in this way, an output power generated by the whole solar cell array is not much reduced even if power reduction would be caused by a reason such that a part of the modules is placed in shade, if the serially-connected modules respectively generate the same level of output power.

Though mentioning a size or the like of a solar cell panel, the Patent Document 2 specified below has little notion that the panels are placed on a roof and further that the panels are overlapped.

Further, the known arts relating to the present invention include the Patent Documents 3 to 9 specified below.
In Fig. 25 in the Patent Document 3, such a configuration that conducting wires are pulled out from a longer edge of a solar cell panel is disclosed. However, the conducting wires of a solar cell module described in the Patent Document 3 are short and are not pulled out from the module, judging from a positional relationship of the solar cell panel and a base member 62.
The solar cell module in the Patent Document 3 has two conducting wires, one being a positive wire and the other being a negative wire.
The Patent Documents 4 and 5 each disclose such a configuration that two cables are pulled out from an eaves side of a solar cell module. In the configurations disclosed in the Patent Documents 4 and 5, each of the two cables has only one core and connects the solar cell modules in series.
Also in the configuration described in the Patent Document 4, as disclosed in Figs. 20 and 21 in the document, the connected cables are housed in a back of the solar cell module from which said cables are pulled out or in a back of the solar cell module in the same level (same row).
In the Patent Document 5, the solar cell modules are placed flat and not placed one above the other. Also in the Patent Document 5, most of the cables are housed in a back of the solar cell module from which said cables are pulled out.
The Patent Document 6 discloses such a configuration that two cables are pulled out from a ridge side of a solar cell module. In the configuration disclosed in the Patent Document 6, the cables are wired at a part separate from a part where the solar cell modules are arranged.
The Patent Document 7 has such a configuration that two cables are pulled out from a ridge side of a solar cell module, the cables being connected at a back side of a solar cell module belonging to an adjacent row. In the configuration disclosed in the Patent Document 8, each of the two cables has only one core and connects the solar cell modules in series. The invention described in the Patent Document 7 is characterized in that flat connectors are used. The solar cell module in the Patent Document 7 has a flat main body, at the bottom of which the flat connectors are arranged.
The module in the Patent document 7 is of a rectangular shape with the two cables pulled out from a shorter edge of the module.

The inventions using cables or the like disclosed in the Patent Documents 8 and 9 specified below are disclosed as a method for connecting a plurality of solar cell modules.

The Patent Document 8 discloses such a configuration that four cables are connected to a solar cell module, and further, such a configuration that a plurality of solar cell modules connected in parallel are connected in series. In the Patent Document 8, a plurality of modules are connected in parallel by directly connecting adjacent cables. In the configurations described in the Patent Document 8 as disclosed in Fig. 8 in the document, the connected cables are housed in a back of the solar cell module from which said cables are pulled out or in a back of the solar cell module in the same level (same row).
The Patent Document 9 discloses such a configuration that four cables are connected to a solar cell module, further, that the cables includes a long one and a short one, and further, that the cables are different in color.
Also in the configurations described in the Patent Document 9, as disclosed in Fig. 7 in the document, the connected cables are housed in a back of the solar cell module from which said cables are pulled out or in a back of the solar cell module in the same level (same row).
[Patent Document 1] JP H11-298017 A
[Patent Document 2] WO 2007/074683 A1
[Patent Document 3] WO 2003/029577 A1
[Patent Document 4] JP 2000-282647 A
[Patent Document 5] JP2002-329881 A
[Patent Document 6] JP 2002-83991 A
[Patent Document 7] JP 2004-14920 A
[Patent Document 8] JP 2004-349507 A
[Patent Document 9] JP 2008-130902 A

### DISCLOSURE OF INVENTION

### TECHNICAL PROBLEM

In a case where a solar cell array is constituted by the above-mentioned connecting structure, an output power generated by the whole solar cell array is not much reduced even if the modules have individual difference in output performances, if the solar cell blocks respectively generate the same level of output power, as well as the case where power reduction would be caused by a reason such that a part of the modules is placed in shade. However, the combined effect of various conditions such as variability in output performances of the solar cell modules and insolation condition of the installation site might cause variability in output characteristics among the modules and fail in effective utilization of an output power of the modules normally operating, resulting in failure in outputting an expected power of the whole solar cell array. Thus, in view of potential for unexpected temporary power reduction caused by a reason such that the modules are arranged in shade, there has been a desire to minimize individual difference in output performances of the modules. Meanwhile, in view of easy manufacture and easy arrangement on a house of the modules, it is impractical to finely adjust output performances by changing a configuration or a size for each module. Therefore, it has been desired to provide a solar cell module having a uniform configuration and a size enabling easy wiring in arrangement.

The present invention therefore aims to provide a solar cell module having a uniform configuration, presenting stable output characteristics, and having a size enabling easy wiring in arrangement and a solar cell array presenting stable output characteristics by employment of said solar cell module.

### SOLUTION TO PROBLEM

In order to solve the above-mentioned problem, an aspect of the present invention provided herein is a solar cell module to be arranged on a roof of a house and to constitute a solar cell array formed by electrically connecting in series a plurality of solar cell blocks formed by electrically connecting a plurality of the solar cell modules in parallel.
The module in this aspect has longer edges and shorter edges with a total length of each of the longer edges of 920 to 1200 mm and a total length of each of the shorter edges of 240 to 700 mm.
The module includes a solar cell panel, the solar cell panel being formed in a substantially rectangular plane with longer edges and shorter edges and having a length of the longer edges of 900 to 1200 mm and a length of the shorter edges of 230 to 650 mm, and is arranged so that the longer edges of the panel extend in a ridge direction of the house and the shorter edges of the panel extend in a direction perpendicular to the ridge direction of the house.
The solar cell panel includes a plurality of unit solar cells and is formed by electrically connecting the cells in series so as to have an open-circuit voltage of 100 to 180 volts.
The unit solar cells each are of a strip-like shape with longer edges and shorter edges, the shorter edges having a length of 7 to 12 mm, and are arranged in lines in a longer-edge direction of the panel so that the longer edges extend in a shorter-edge direction of the panel and the shorter edges extend in the longer-edge direction of the panel.
The module further includes two positive conducting wires in electrical connection with a positive electrode of the solar cell panel and two negative conducting wires in electrical connection with a negative electrode of the solar cell panel.
The two positive conducting wires and the two negative conducting wires each are pulled out from one of the longer edge of the module.
The module has a space for accommodating the two positive conducting wires and the two negative conducting wires of another panel in a back of the module.
The module has an overlapping portion for overlapping a part of another module on its top face.

The solar cell module in this aspect incorporates the solar cell panel having the length of the longer edges of 900 to 1200 mm, so as to be easily carried in and arranged at a place such as a roof of a house, where the arrangement work is difficult. Further, the module has the total length of the longer edge of 920 to 1200 mm and the total length of the shorter edge of 240 to 700 mm. Thus, the solar cell module in this aspect has the length of the longer edges being about twice a size of a common roof tile, so as to be arranged on a house with a working efficiency not much different from tiling.
Herein, the total length of the module excludes the length of the cables.

The solar cell panel constituting the solar cell module in this aspect includes a plurality of strip-like unit solar cells each having the width of 7 to 12 mm electrically connected in series and aligned in the longer-edge direction of the panel, so that the modules have the uniform configuration. Further, the above-mentioned uniform configuration employed in the modules in this aspect minimizes output variability. Still further, the cell panel constituting the module in this aspect has the open-circuit current of 100 to 180 volts, so that the solar cell array capable of outputting a voltage suitable to be inputted in a device such as the known AC power conditioner is constructed by electrically connecting a plurality of the panels in parallel so as to form a solar cell block and connecting a plurality of solar cell blocks in series.

In the module in this aspect, the unit cells are arranged in lines in the longer-edge direction of the panel so that the longer edges extend in the shorter-edge direction of the panel and the shorter edges extend in the longer-edge direction of the panel. Further, the modules in this aspect are arranged so that the longer edges of the panel extend in the ridge direction of the house and the shorter edges of the panel extend in the direction perpendicular to the ridge direction of the house. Herein, when the modules are arranged on a house in a similar manner as common tiling, some modules might be hidden behind another module above in the direction perpendicular to the ridge depending on insolation conditions or overlapped with another module at a portion below in the direction perpendicular to the ridge, resulting in formation of some portion unable to generate electricity or having considerable output reduction, which may cause electric resistance. However, even if such a portion is formed, the unit cells normally operate at other portions, so that all the unit cells are maintained in electrical connection with one another. Consequently, the solar cell module in this aspect minimizes an effect on power reduction of the entire solar cell array even if output power is reduced because of the insolation conditions or the like.

The module further includes the two positive conducting wires in electrical connection with a positive electrode of the solar cell panel and the two negative conducting wires in electrical connection with a negative electrode of the solar cell panel, both which are pulled out from the longer edge of the module.

In this aspect, the module is of a substantially rectangular shape with the four conducting wires pulled out from the longer edge of the module. That allows connection of the cables outside a body of the module. Further, the module in this aspect has the overlapping portion for overlapping a part of another module on its top face.
The modules belonging to an adjacent row are arranged on the previously-connected cables by placing said modules after the connection of the cables.
Further, in the present aspect, arrangement of the modules belonging to an adjacent row after the connection of the cables allows the previously-connected cables to be housed in the spaces of the modules belonging to the adjacent row.

In the module in this aspect described above, the unit solar cells each preferably have the open-circuit voltage of 1.2 to 1.5 volt.

By this configuration, there is provided the solar cell module capable of outputting the open-circuit voltage required for construction of the solar cell array.

The overlapping portion is preferably formed on a part except a top face of the solar cell panel.

In the solar cell module in this aspect described above, the unit solar cell may be of a tandem type.

This configuration utilizes energy contained in incident light to the maximum, so as to provide the solar cell module having a high energy conversion efficiency.

In the solar cell module in this aspect described above, the solar cell panel preferably has a short-circuit current of 9 to 15 mA/cm².

As described above, in the solar cell module constituted by a number of the unit cells connected in series, failure of electricity generation by a part of a specific unit cell due to a reason such as being in shade might cause a hot spot phenomenon in which heat is generated because the electric resistance is increased at the part. Such a hot spot phenomenon might cause a problem such as deterioration or breaking of the module and reduce specific output of the module as subsequent events. That might cause output variability of the modules constituting the solar cell array or the solar cell blocks, resulting in failure in utilizing a part of electric energy generated in the other modules.

In view of such a drawback, the solar cell module in this aspect described above is therefore preferably configured in such a manner that the unit solar cells each have an effective electricity-generating area where electricity is generated upon reception of light and that the module has at least one dividing line extending in the longer-edge direction of the module and dividing the effective electricity-generating area of the unit solar cell.

Even if a part of a specific module would fails to generate electricity due to a reason such as being in shade, this configuration protects the part from being subjected to considerably large electric resistance, thereby preventing deterioration or breaking of the module caused by such a hot spot phenomenon. Consequently, the above-mentioned configuration minimizes individual difference in output performances of the solar cell modules due to a hot spot phenomenon after arrangement of the solar cell array.

The solar cell module preferably has grooves through which a cable is inserted in the shorter-edge direction in the back of the module.

A solar cell array in another aspect of the present invention is formed by serially connecting two solar cell blocks, the solar cell blocks each being formed by electrically connecting in parallel a plurality of the solar cell modules in the above-mentioned aspect.

The present aspect employs the solar cell modules in the foregoing aspect, which has small individual difference in output performances of the modules. Further, the array in this aspect is formed by serially connecting a plurality of solar cell blocks, each of which is formed by connecting the modules in parallel. Thus, even if a part of the solar cell module would cause power reduction, it is possible to minimize energy loss resulting from the power reduction and present stable output performances.

In the solar cell array in this aspect described above, the solar cell blocks each are preferably formed by electrically connecting twenty or more of the solar cell modules in parallel.

In the above-mentioned array, it is preferable that a plurality of the modules are arranged in a plane in a plurality of rows each consisting of the modules and that the positive conducting wire of one of adjacent modules and the negative conducting wire of the other of the adjacent modules are connected to each other with the connected conducting wires housed in the space of the module in an adjacent row.

This configuration makes the connected cables to fit into place, thereby facilitating the arrangement work.

In the above-mentioned array, the one positive conducting wire and the one negative conducting wire of the module located at an end of one row and the one positive conducting wire and the one negative conducting wire of the module located at an end of its adjacent row are preferably connected to each other and housed in the space of the module of the next row but one.

In an arrangement structure of solar cell modules using the modules each being of a substantially rectangular shape and having a plurality of unit solar cells formed inside thereof so as to constitute a solar cell as a whole and arranging the modules on a structural object, the solar cell modules each may include two connectors and cables, the cables each having more than one conducting wire and pulled out from a center part of a longer edge of the module, the two connectors each having more than one individual terminal and being connected to the respective cables, wherein the one terminal of each connector is a positive terminal connected to a positive electrode of the solar cell and the other terminal of each connector is a negative terminal connected to a negative electrode of the solar cell, wherein the cable connected to the one connector is shorter than the cable connected to the other connector, wherein, when a plurality of the modules are arranged in a row, the cables have a length relationship in which the connectors connected to the short cables are unconnectable to each other because the cables are not long enough, and wherein the modules are arranged in a row on the structural object so that the connector connected to the long cable of one of adjacent modules and the connector connected to the short cable of the other of the adjacent modules are connected to each other with the positive terminals of the both connectors connected to each other and with the negative terminals of the both connectors connected to each other, and whereby a plurality of the modules electrically connected in parallel.

In the above-mentioned arrangement structure of the modules, the connectors of the adjacent module are connected in such a manner that the connector connected to the long cable and the connector connected to the short cable are connected to each other. In the arrangement structure described above, it is normal that the connector connected to the long cable and the connector connected to the short cable are connected to each other in this way. According to the arrangement structure described above, connection of the connector connected to the long cable and the connector connected to the short cable in connection of adjacent modules in this way achieves connection of the positive terminals and connection of the negative terminals of the both connectors. That electrically connects a plurality of the modules in parallel.
Further, the arrangement structure described above prevents workers from improper connection of the connectors. Since the arrangement structure described above has the long and short cables in this way, the connectors connected to the short cables are unconnectable to each other because of lack of length when arranged with the other modules in a row. Therefore, when the modules are arranged on a structural object such as a roof, the short cables of adjacent modules are physically unconnectable to each other. That prevents workers from improper connection of the connectors.

### ADVANTAGEOUS EFFECT OF INVENTION

The present invention provides a solar cell module having a uniform configuration, presenting stable output performances, and having a size enabling easy wiring in arrangement and a solar cell array presenting stable output performances by employment of said solar cell modules.

### BRIEF DESCRIPTION OF DRAWINGS

Fig. 1A is a perspective view of a solar cell module embodying the present invention and Figs. 1B and 1C each are a cross-section of a connector in the solar cell module;
Fig. 2 is a perspective view showing a structure of a back of the module in Fig. 1;
Fig. 3 is a cross section of a solar cell panel employed in the solar cell module shown in Fig. 1;
Fig. 4 is another cross-section of the connector of the module in Fig. 1;
Fig. 5 is a flow chart showing a work procedure of arrangement of the solar cell modules;
Fig. 6A is a view illustrating a roof of a house and Fig 6B is a view illustrating the roof of the house arranged with the solar cell modules.;
Fig. 7 is a conceptual diagram showing a module row in which the solar cell modules are properly connected;
Fig. 8 is a conceptual diagram showing a module row in which the solar cell modules are improperly connected;
Fig. 9 is a circuit diagram of wiring in which the solar cell modules are properly connected;
Fig. 10 is a conceptual diagram showing a solar cell array;
Fig. 11A is a front view of a service cable and Fig. 11B is a cross-section of a molded portion of the service cable;
Fig. 12 is a plan view of a terminal protector;
Fig. 13A is a plan view of a connector with male portions at both electrodes and Fig. 13B is a plan view of a connector with female portions at both electrodes;
Fig. 14 is a perspective view of a modified embodiment of the solar cell module shown in Fig. 1;
Fig. 15 is a front view of a cable for voltage test;
Fig. 16 is an exploded perspective view of the solar cell module in Fig. 1;
Fig. 17 is a cross section showing the solar cell module in Fig. 1 arranged adjacent to the eaves on a top face of a house;
Figs. 18A and 18B each are a perspective view illustrating arrangement of the solar cell module adjacent to the eaves of a house having a roof structure in the present embodiment. Fig. 18A shows a state before the arrangement and Fig. 18B shows a state after the arrangement;
Fig. 19 is a perspective view illustrating arrangement of the solar cell modules after the first module row in the roof structure in the present embodiment;
Fig. 20 is a partial cross-section illustrating arrangement of the solar cell module after the first module row in the roof structure in the present invention;

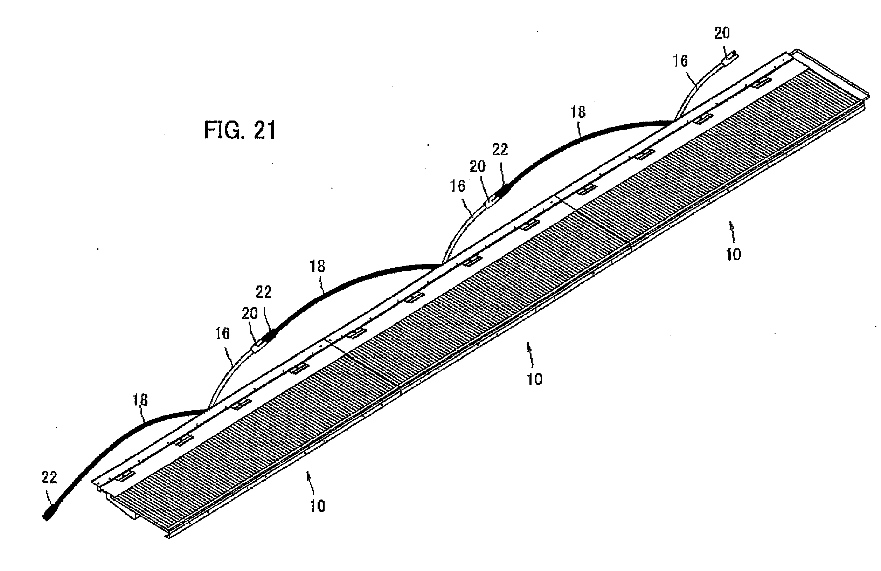

Fig. 21 is a perspective view illustrating a cable wiring of the solar cell modules in the roof structure in the present embodiment;
Fig. 22 is a perspective view illustrating a relationship between a cable connection of the solar cell modules belonging to a specific module row in the roof structure in the present embodiment and the solar cell modules belonging to an adjacent module row;
Fig. 23 is a perspective view showing a cable wiring of the solar cell modules in the roof structure in the present embodiment observed from a back of the modules;
Fig. 24 is a perspective view showing the cable wiring of the solar cell modules at a portion adj acent to the end of the row in the roof structure in the present embodiment observed from the back of the modules;

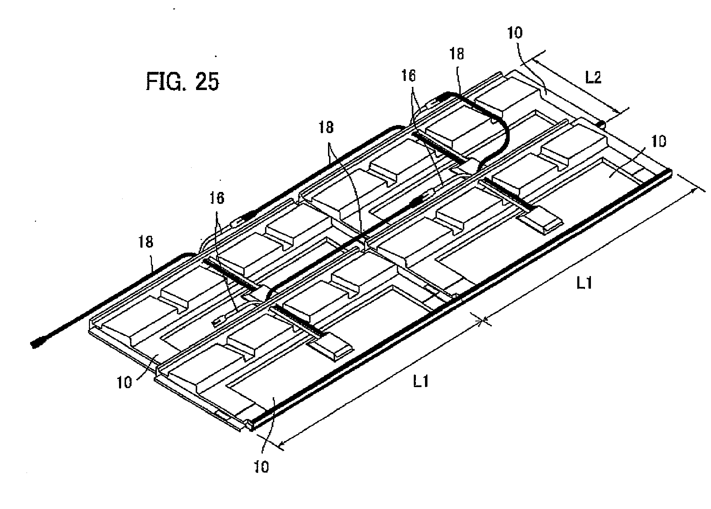

Fig. 25 is a view illustrating sizes of the modules and lengths of the cables when the modules are arranged on a roof with rows and columns justified;
Fig. 26 is a view illustrating sizes of the modules and lengths of the cables when the modules are arranged on a roof with upper and lower rows shifted by a quarter of the length;
Fig. 27 is a view illustrating sizes of the modules and lengths of the cables when the modules are arranged on a roof with upper and lower rows shifted by a half of the length; and
Fig. 28 is a view illustrating sizes of the modules and lengths of the cables when the modules are arranged on a roof with upper and lower rows shifted by three quarters of the length.

### DESCRIPTION OF EMBODIMENTS

Now, a solar cell module 10 and a solar cell array 1 relating to an embodiment of the present invention will be described in detail below, making reference to the accompanying drawings.

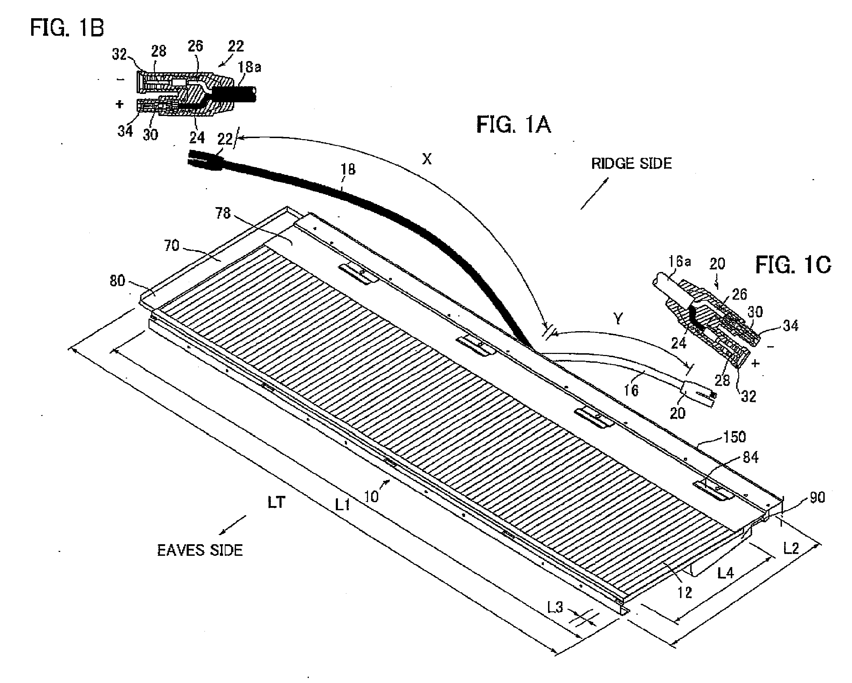

In the descriptions below, a vertical positional relationship is based on a positional relationship shown in Fig. 1.

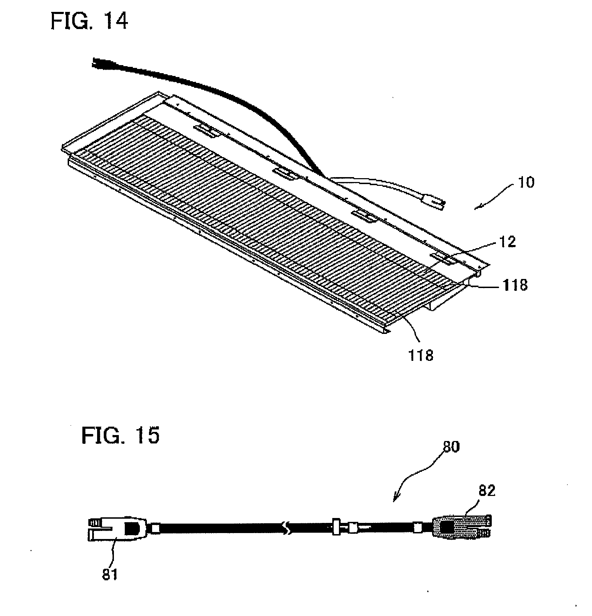

As shown in Figs. 1A and 14, the solar cell module 10 consists mainly of a base 82 constituted by a base member 70 attached with a reinforcing heat insulator 90 and other members such as a solar cell panel 12, a front cover 102, and hooking brackets 84 mounted on the base 82.

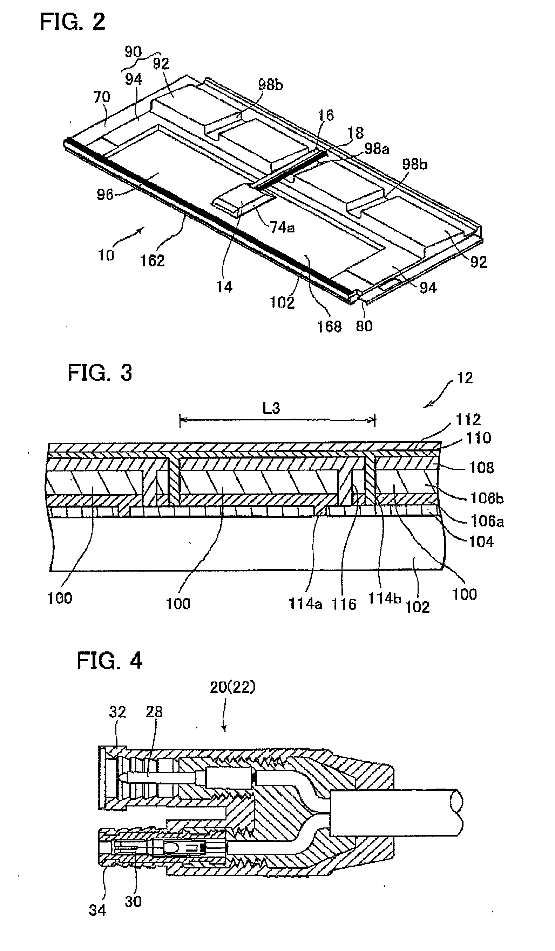

The module 10 in the present embodiment is a roof-tile-shaped solar cell module applied to a roof R of a newly-built or already-built house. As shown in Figs. 1A to 1C and 2, the solar cell module 10 is provided with the solar cell panel 12, a terminal box 14 attached to a back of the panel 12, two cables 16 and 18 pulled from the terminal box 14, and connectors 20 and 22 connected to the respective cables 16 and 18.

It is necessary that the module 10 has a total length of a longer edge of 920 to 1200 mm and a total length of a shorter edge of 240 to 700 mm.
It is necessary that the panel 12 mounted on the module 10 has a length of a longer edge of 900 to 1200 mm and a length of a shorter edge of 230 to 650 mm.
Next, recommendable sizes of the module 10 and the panel 12 will be described below, each being a size in the embodiment shown in Figs. 1A and the followings.

The solar cell module 10 is formed in a substantially rectangular plane as shown in Figs. 1A and 2. In the module 10, most of area exposed outside when the module 10 is arranged is occupied by the panel 12. Therefore, the module 10 has substantially the same size as or slightly larger than the panel 12. In this embodiment, a total length LT of the module 10 is longer than a total length L1 of the panel 12 by a width of a trough-like gutter 80.
The module 10 in this embodiment has the total length LT of the longer edge smaller than 1200 mm in view of ensuring output and simultaneously workability in arrangement work on a house. Herein, the total length LT of the module 10 excludes lengths of the cables 16 and 18.
In this embodiment, the panel 12 has the total length L1 in a range of 900 to 1100 mm in view of intervals of common scaffolds laid in arrangement of the modules 10 and easy handling by workers.
The panel 12 has a length (width) L4 of its shorter edge in a range of 250 to 320 mm.
Further, the solar cell module 10 has a length L2 of its shorter edge in a range of 240 to 480 mm in view of a size of a common flat roof tile. In this embodiment, the module 10 is adjusted to have the length L2 in a range of 280 to 360 mm in view of improvement of incident phonon-to-current conversion efficiency by minimizing a part hidden behind depending on an insolation condition with an effective width no less than the common flat roof-tile.

The panel 12 is formed in a substantially rectangular plane as shown in Figs. 1A and 2. The solar cell panel 12 is arranged with its longer edges extending in a ridge direction (direction parallel to the ridge) of a house and its shorter edges extending in a direction perpendicular to the ridge of the house. The panel 12 is formed by arranging a number of unit solar cells 100 (hereinafter referred to as a unit cell 100), each being of a strip-like shape, in a longer-edge direction of the panel 12 so as to be electrically connected in series. One panel generates a voltage of about 100 volts.

The panel 12 is a combination of more than one photoelectric conversion layer or a so-called tandem solar cell, having high incident photon-to-current conversion efficiency. This embodiment employs a hybrid solar cell of one-body system of a tandem type as the solar cell panel 12. More specifically, as shown in Fig. 3, the panel 12 is a so-called hybrid solar cell by sequentially laminating a transparent front electrode layer 104, a first and second thin film photoelectric conversion units 106a, 106b (hereinafter also referred to as an amorphous photoelectric conversion unit 106a and a crystalline photoelectric conversion unit 106b), a metal back electrode layer 108, an encapsulation resin layer 110, an organic protection layer 112 on a transparent substrate 102. The transparent substrate 102 is made of a material having translucency such as a glass plate and a transparent resin film and constitutes a face closest to incident light when the modules 10 are arranged.

The transparent front electrode layer 104 is a layer having a single layer structure or a multilayer structure arranged at a position next to the transparent substrate 102. The electrode layer 104 is formed by laminating an oxide having transparency and electric conductivity, such as an ITO film, a SnO₂ film, and a ZnO film, on the transparent substrate 102 in laminae. The electrode layer 104 is formed by a method such as the known vapor deposition method as typified by an evaporation method, a CVD (Chemical Vapor Deposition) method, an EVD (Electrochemical Vapor Deposition) method, and a sputtering method.

The thin film photoelectric conversion unit 106a has an amorphous photoelectric conversion layer and is arranged at a position next to the transparent front electrode layer 104 in a direction of incident light (from below in Fig. 3). The photoelectric conversion unit 106a may have a laminated configuration in which a p-type silicon semiconductor layer, an i-type silicon amorphous photoelectric conversion layer, and an n-type silicon semiconductor layer are laminated in this order from a side of the layer 104. These p-type silicon semiconductor layer, i-type silicon amorphous photoelectric conversion layer, and n-type silicon semiconductor layer are also formed by an appropriate method such as a plasma CVD method as well as the above-mentioned layer 104. The photoelectric conversion unit 106a preferably has a thickness of 0.01 µm to 0.5 µm and more preferably has a thickness of 0.1 µm to 0.3 µm.

The thin film photoelectric conversion unit 106b has a crystalline photoelectric conversion layer and is arranged at a position next to the photoelectric conversion unit 106a in the direction of incident light. The photoelectric conversion unit 106b may have a laminated configuration in which a p-type silicon semiconductor layer, an i-type silicon crystalline photoelectric conversion layer, and an n-type silicon semiconductor layer are laminated in this order from a side of the unit 106a. These p-type silicon semiconductor layer, i-type silicon crystalline photoelectric conversion layer, and n-type silicon semiconductor layer constituting the unit 106b are also formed by a method such as a plasma CVD method as well as the above-mentioned unit 106a.

The crystalline photoelectric conversion layer constituting the unit 106b has a light absorption coefficient lower than the above-mentioned amorphous photoelectric conversion layer constituting the unit 106a. Therefore, the photoelectric conversion unit 106b is preferably several times to ten times thicker than the unit 106a. Specifically, the unit 106b preferably has a thickness of 0.1 µm to 10 µm and more preferably has a thickness of 0.1 µm to 5 µm.

The p-type semiconductor layer constituting the photoelectric conversion units 106a, 106b described above is formed by doping p-type conductivity-determining impurity atoms such as boron and aluminum into silicon, silicon carbide, or silicon-containing alloy such as silicon-germanium alloy. The amorphous photoelectric conversion layer and the crystalline photoelectric conversion layer are formed by an amorphous silicon semiconducting material and a crystalline silicon semiconducting material respectively. Specifically, the amorphous photoelectric conversion layer and the crystalline photoelectric conversion layer are constituted by an intrinsic semiconductor such as silicon (hydrogenated silicon or the like), silicon carbide, and silicon-containing alloy such as silicon-germanium alloy. Further, the amorphous photoelectric conversion layer and the crystalline photoelectric conversion layer require only a photoelectric conversion function and may be constituted by using a weak p-type or a weak n-type silicon semiconducting materials containing trace conductivity-determining impurity, for example. The n-type semiconductor layer constituting the amorphous photoelectric conversion layer and the crystalline photoelectric conversion layer is formed by doping n-type conductivity-determining impurity atoms such as phosphorus and nitrogen into silicon, silicon carbide, or silicon-containing alloy such as silicon-germanium alloy.

Further, the above-mentioned photoelectric conversion units 106a, 106b are different in absorption wavelength ranges. Specifically, the photoelectric conversion layer of the unit 106a constituted by the amorphous silicon most effectively absorbs an optic element of about 550 nm, while the photoelectric conversion layer of the unit 106b constituted by the crystalline silicon most effectively absorbs an optic element of about 900 nm.

The metal back electrode layer 108 is arranged at a position next to the thin film photoelectric conversion unit 106b in the direction of incident light. The electrode layer 108 is constituted by a material such as silver and aluminum and formed to have a thickness of about 200 nm to 400 nm by a method such as the known evaporation and a sputtering method. Between the metal back electrode layer 108 and the photoelectric conversion unit 106b, a transparent electroconductive thin film (not shown) made of a nonmetal material such as ZnO may be appropriately provided in view of improvement of adhesion between those. The layer 108 has a function as a reflecting layer for reflecting light, which incomes through the transparent substrate 102 and passes through the units 106a, 106b, so as to make the light to enter the units 106a, 106b again in addition to a function as an electrode of the cell panel 12.

The module 10 has the organic protection layer 112 via the encapsulation resin layer 110 at a position next to the metal back electrode layer 108 in the direction of incident light, that is, at a position coming to a back of the module 10 when the module 10 is arranged on a house. The encapsulation resin layer 110 bonds the organic protection layer 112 and the metal back electrode layer 108 and is formed by a material such as EVA (ethylene vinyl acetate copolymer), PVB (polyvinyl butyral), PIB (polyisobutylene), and silicone resin. The organic protection layer 112 encapsulates the back face of the module 10. The organic protection layer 112 may suitably employ an insulation film having high resistance to humidity and water like a fluorine resin film such as a polyvinyl fluoride film and a PET (polyethylene terephthalate) film, a film formed by lamination of those films, or a film formed by sandwiching a metal foil made of aluminum or the like by those films.

As shown in Fig. 3, in the solar cell module 10, a plurality of unit cells 100 are defined by dividing the resulting thin films laminated as described above by a first and a second dividing grooves 114a, 114b and a connecting groove 116. In other words, the first and the second dividing grooves 114a, 114b and the connecting groove 116 each are formed between adjacent unit cells 100 so as to divide the thin films constituting the layers such as the transparent front electrode layer 104, the thin film photoelectric conversion units 106a, 106b, and the metal back electrode layer 108 into a plurality of cells. The first and the second grooves 114a, 114b and the connecting groove 116 each have a linear shape and are formed so as to extend in a direction perpendicular to the plane of paper in Fig. 3, that is, along the shorter edges of the module 10 and in parallel with respect to one another.

The first dividing groove 114a divides the transparent front electrode layer 104 into unit cells 100. The first dividing groove 114a has an opening at a boundary between the transparent front electrode layer 104 and the photoelectric conversion unit 106a and its bottom at a surface of the transparent substrate 102. The groove 114a is filled with a material such as amorphous silicon constituting the unit 106a. Thus, the transparent front electrode layer 104 of the unit cell 100 is electrically insulated from the transparent front electrode layer 104 of another unit cell 100 adjacently located in the longer-edge direction of the module 10 by the material such as amorphous silicon filled in the first dividing groove 114a.

The second dividing groove 114b defines a boundary between adjacent unit cells 100. The second dividing groove 114b is formed at a position shifted relative to the first dividing groove 114a in the longer-edge direction of the module 10. The second dividing groove 114b is formed so as to divide the photoelectric conversion units 106a, 106b and the metal back electrode layer 108 into unit cells 100. The groove 114b has an opening at a boundary between the metal back electrode layer 108 and the encapsulation resin layer 110 and its bottom at a surface of the transparent front electrode layer 104. The groove 114b is filled with resin such as the above-mentioned EVA (ethylene vinyl acetate copolymer) constituting the layer 110. Thus, the metal back electrode layer 108 of the unit cell 100 is electrically insulated from the metal back electrode layer 108 of another unit cell 100 adjacently located by the resin filled in the second dividing groove 114b.

The connecting groove 116 is formed between, the first and the second dividing grooves 114a, 114b. The connecting groove 116 divides the photoelectric conversion units 106a, 106b into unit cells 100. The groove 116 has an opening at a boundary between the photoelectric conversion unit 106b and the metal back electrode layer 108 and its bottom at a surface of the transparent front electrode layer 104. The groove 116 is filled with a metal material such as silver and aluminum constituting the layer 108, so as to electrically connect the layer 108 of one of adjacent unit cells 100 and the layer 104 of the other of the adjacent unit cells 100. In other words, a number of the unit cells 100 formed in the module 10 are electrically connected to the respective adjacent unit cells 100 in series by the metal material filled in the groove 116.

Each of the unit cells 100 is preferably formed so as to have a width (shorter edges) L3 of 7 to 12 mm and more preferably of 8 to 10 mm in view of a balance between an electricity-generating area and an electrode resistance, accuracy and easiness of manufacture, minimization of output variability, or the like. Each of the unit cells 100 has a length of the longer edges slightly shorter than the length L4 of the shorter edges of the cell panel 12 and of about three quarters of the length L2 of the module 10. Therefore, each of the unit cells 100 is of a strip-like configuration from a side of the transparent substrate 102. The unit cell 100 is a tandem (hybrid) solar cell provided with the thin film photoelectric conversion units 106a, 106b and obtains an open-circuit voltage in a range of 1.2 to 1.5 volts by the added open-circuit voltage of the two units, which is higher than the voltage obtained by a solar cell constituted by one unit. The cell panel 12 is formed by the serially-connected 50 to 150 cell units 100, so as to be configured to output the open-circuit voltage of 100 to 180 volts as a whole. In the cell panel 12 in this embodiment, a number of cell units 100 are serially connected so as to output the open-circuit voltage of about 100 volts as a whole. The cell panel 12 is preferably formed to have a short-circuit current value in a range of 9 to 15 mA/cm² and more preferably of 10 to 15 mA/cm².

The longer edges of each of the cell units 100 extend in the shorter-edge direction of the cell panel 12 and the shorter edges thereof extend in the longer-edge direction of the cell panel 12. Thus, in the cell panel 12, an area of a portion functioning as a connecting part of the cell units 100, that is, an area of the first and the second dividing grooves 114a, 114b and the connecting groove 16 is minimized. Further, arrangement of the cell units 100 in the cell panel 12 as described above prevents a so-called hot spot phenomenon even when a part of the cell panel 12 is located in shade or dust and trash are accumulated around the bottom (an eaves-side edge) of the cell panel 12.

As shown in Fig. 2, the solar cell module 10 is provided with the terminal box 14 at the back of the panel 12 and the first and the second cables 16, 18 pulled out from the terminal box 14. The terminal box 14 has inside a plus electrode-connecting terminal (not shown) connected to a positive electrode of the panel 12 and a minus electrode-connecting terminal (not shown) connected to a negative electrode of the panel 12. Within the terminal box 14, there are provided two positive inner wires 24, which are black coated wires, connected to the plus electrode-connecting terminal and two negative inner wires 26, which are white coated wires, connected to the minus electrode-connecting terminal.

The first and the second cables 16, 18 are used for electrically connecting a plurality of the solar cell modules 10 to one another when the solar cell array 1 is constructed by arranging the modules 10. As shown in Fig. 1, the first cable 16 is formed by bundling one wire 24 of the positive inner wires 24, 24 and one wire 26 of the negative inner wires 26, 26. The second cable 18 is formed by bundling the other wire 24 of the positive inner wires 24, 24 and the other wire 26 of the negative inner wires 26, 26.

As shown in Figs. 1B and 1C, the first cable 16 and the second cable 18 are different in color, the first cable 16 having the positive inner wire 24 and the negative inner wire 26 put together in a white insulation tube 16a and the second cable 18 having the positive inner wire 24 and the negative inner wire 26 put together in a black insulation tube 18a.

Further, the first cable 16 and the second cable 18 are different in length, one being longer than the other. Specifically, the first cable 16 is shorter than the second cable 18. The first cable 16 has a total length of less than 50 % of the length L1 of the longer edges of the rectangular panel 12, while the second cable 18 has a total length of 50 % or more of the length L 1.

Herein, a sum of the lengths of the first cable 16 and the second cable 18 is longer than the length L 1.

More specifically, the second cable 18 is, as shown in Fig. 1A, pulled out from a longer edge (upper side edge) 150 of a ridge side of the module 10 toward the ridge side (upper side), having a length X of a part pulled out from the longer edge 150 to the connector 22 without a length of the connector 22, the length X being 50 % or more of the length L1 of the panel 12 of the module 10.
The more recommended length X is 50 % or more of the length L1 and simultaneously longer than the length L4 of the shorter edges of the panel 12 and shorter than the length L 1.
Specifically, the length X of the second cable 18 is longer than (L1/2) and longer than L4 when the length of the longer edges of the panel 12 is designated as L1 and the length of the shorter edges of the panel 12 is designated as L4. The more recommended length X is longer than a sum of (L1/4) and L4 and shorter than a sum of ((L1/4) x 3) and L4.
Further, the length X of the second cable 18 may be of a length obtained by the above-mentioned formulae using L2 instead of L4 in view of flexibility for connection. That is, the length X of the second cable 18 is longer than (L1/2) and longer than L2 when the length of the longer edges of the panel 12 is designated as L1 and the length of the shorter edges of the module 10 is designated as L2. The more recommended length X is longer than a sum of (L1/4) and L2 and shorter than a sum of ((L1/4 x 3) and L2.

Meanwhile, the first cable 16 has a length Y of a part pulled out from the longer edge 150 is shorter than the length X of the second cable 18 and shorter than (L1/2).
Further, the length Y is shorter than the length L4 of the shorter edges of the panel 12.
The length X of the first cable 16 may be of a length obtained by the above-mentioned formulae using L2 instead of L4 in view of flexibility for connection. That is, the length Y of the first cable 16 is shorter than L2 of the shorter edges of the module 10.

As shown in Fig. 1A to 1C, the first cable 16 and the second cable 18 have the first connector 20 and the second connector 22 respectively attached to the respective ends. The first connector 20 and the second connector 22 have the same configuration though being different in color. In this embodiment, the first connector 20 is white, while the second connector 22 is black.

As shown in Fig. 4, the first connector 20 and the second connector 22 each are provided with a pin terminal 28 and a socket terminal 30. The first and the second connectors 20 and 22 each are provided with a female portion 32 and a male portion 34 with the pin terminal 28 being within the female portion 32 and the socket terminal 30 being within the male portion 34.

As shown in Figs. 1B and 1C, in this embodiment, the positive inner wire 24 is connected to the pin terminal 28 of the first connector 20, while the negative inner wire 26 is connected to the socket terminal 30 of the first connector 20. In contrast, the negative inner wire 26 is connected to the pin terminal 28 of the second connector 22, while the positive inner wire 24 is connected to the socket terminal 30 of the second connector 22. That is, in the first connector 20, the pin terminal 28 is a positive electrode and the socket terminal 30 is a negative electrode. In contrast, in the second connector 22, the pin terminal 28 is a negative electrode and the socket terminal 30 is a positive electrode. Therefore, in the first connector 20 and the second connector 22, the female portion 32 of one of the connectors 20, 22 is engaged with the mail portion 34 of the other of the connectors 20, 22 and whereby the pin terminal 28 of the one of the connectors 20 and 22 is connected to the socket terminal 30 of the other of the connectors 20 and 22, so that electrodes having the same polarity are electrically connected in parallel.

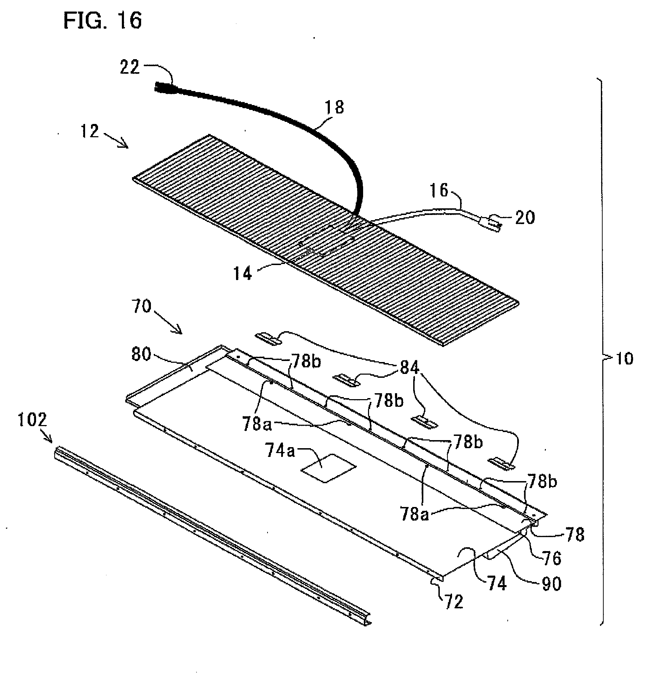

As shown in Fig. 16, the base member 70 is made of a plate of a substantially rectangular shape, which is formed into a predetermined shape by bending a piece of metal plate or a plurality of metal plates. Production of the base member 70 by a piece of metal plate is easily worked, reduces production costs, and further allows a configuration without a connected portion, thereby adding the advantage of strength. Thus, the base member 70 is preferably made by bending a piece of metal plate in view of those advantages.

On the base member 70 produced as described above, a cover attaching portion 72, a solar-cell arranging portion 74, a ridge-side fixing portion 76, and an overlapping portion 78 are formed in this order from the eaves side, the ridge-side fixing portion 76 being for fixing a ridge side of the solar cell panel 12 arranged on the solar-cell arranging portion 74 and the overlapping portion 78 being for being overlapped with an eave-side end portion of the solar cell module 10 or of a common roof tile adjacently arranged on the ridge side (upper row). The base member 70 has the trough-like gutter 80 formed at its side. The base member 70 is preferably made of a metal plate such as a steel plate, an aluminum plate, and a stainless steel plate, and in this embodiment, a Galvalume steel plate is used.

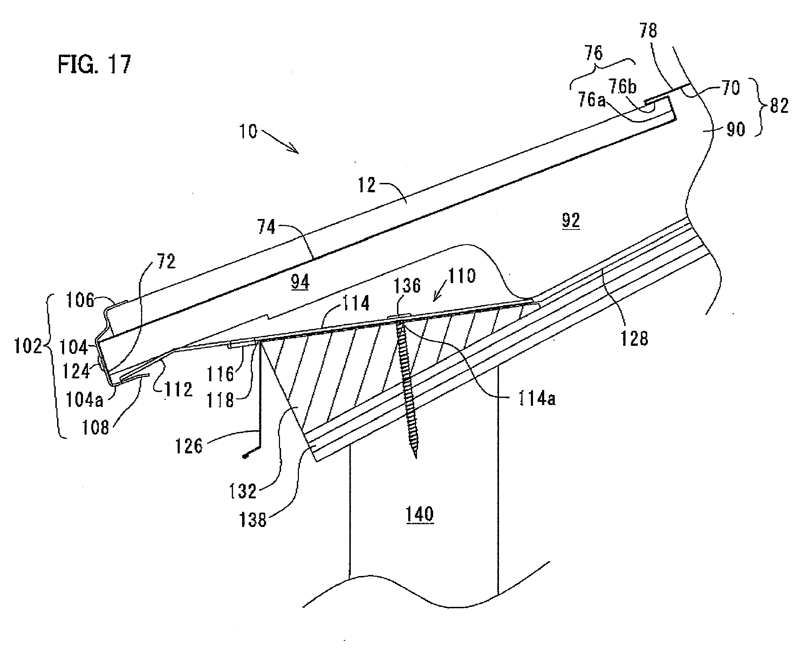

As shown in Fig. 17, the cover attaching portion 72, which is formed by an eave-side end of the base member 70 bent to the back at a substantially right angle, is a portion to which the front cover 102 described below is attached.

The solar-cell arranging portion 74, which is formed in the substantially same size as the panel 12, is a planate portion on which the solar cell panel 12 is arranged. As shown in Fig. 16, the solar-cell arranging portion 74 has an opening 74a in which the terminal box 14 of the panel 12 is inserted at its substantial center part. In the solar cell module 10 in this embodiment, the solar cell panel 12 is mounted on the base member 70 from its front face, so that the terminal box 14, the cables 16, 18, and the connectors 20, 22 come to the back of the base member 70 through the opening 74a, as shown in Fig. 2.

As shown in Fig. 17, the ridge-side fixing portion 76 is a portion for fixing the ridge side of the solar cell panel 12 arranged on the solar cell arranging portion 74. The fixing portion 76 has a rising portion 76a and a surface holding portion 76b, the rising portion 76a being formed by bending the base member 70 to the front face at a substantially right angle at a predetermined position and the surface holding portion 76b being formed by bending the base member 70 to the eaves side at a predetermined position from a proximal end of the rising portion 76a. The rising portion 76a has a contact with a ridge-side end face of the panel 12 and the holding portion 76b covers a part of a surface (light-receiving face) of the panel 12 and puts a pressing force from the surface side.

The overlapping portion 78 is a planate portion formed by bending the base member 70 to the ridge side at a predetermined position from a proximal end of the holding portion 76b of the fixing portion 76. As shown in Fig. 16, the overlapping portion 78 has throughholes 78a at predetermined positions and throughholes 78b at predetermined positions nearer to the ridge side than the throughholes 78a, the throughholes 78a being for securing the hooking brackets 84 described below and the throughholes 78b being for driving in screws therethrough to fix the module 10 to a house.
The overlapping portion 78 is located at an area except an upper face of the solar cell panel 12.

Next, the reinforcing heat insulator 90 will be described, making reference to Fig. 16. The reinforcing heat insulator 90 is a member made of foamed resin attached to the back of the base member 70 for keeping strength and heat insulation of the solar cell module 10. The heat insulator 90 has a ridge-direction reinforcing portion 92 extending in a ridge direction along the ridge-side longer edge of the base member 70 and an inclining-direction reinforcing portion 94 extending in a direction toward eaves (perpendicular to the ridge) along the shorter edges of the base member 70 from the both ends of the ridge-direction reinforcing portion 92. The inclining-direction reinforcing portion 94 is a portion to be overlapped on the overlapping portion 78 of the solar cell module 10 or on a common roof tile adjacently arranged on the eaves side (lower row) and is formed to have a thickness thinner than the ridge-direction reinforcing portion 92.

The heat insulator 90 is arranged along a peripheral part of the base member 70 instead of being arranged on the entire back of the base member 70. Thus, the base member 70 has at its back an accommodation space (gap portion) 96 surrounded by the heat insulator 90 and opening at the eaves side. The terminal box 14 is housed at a substantial center part of the space 96. Further, the wired cables 16, 18 are accommodated in the space 96.

In this embodiment, the cables 16, 18 are pulled out from the longer edge 150 of the ridge side of the solar cell module 10, so that the solar cell modules 10 are connected in parallel by connecting the connectors 20, 22 of the cables 16, 18 of the modules 10 adjacently located on the right and left hands in the same row as described below. The cables 16, 18 are pulled out from the longer edge 150 of the module 10 as described above, so that the connectors 20, 22 are connected above and outside the modules 10. When the modules in an upper row are arranged as described below, the wired cables 16, 18 (including the connectors 20,22) are housed in the space 96 of the modules in the upper row.
Further, there is a gap between the inclining-direction reinforcing portion 94 and a house, through which gap the cables 16,18 are inserted.

The ridge-direction reinforcing portion 92 of the heat insulator 90 has three cable grooves 98, as shown in Fig. 2, at a face opposite to the face with which the base member 70 contacts. The cable grooves 98 communicate from the ridge side to the eaves side, so as to connect inside and outside of the space 96. The cable grooves 98 consist of a center groove 98a located at a substantial center part of the reinforcing portion 92 and side grooves 98b, 98b located at right and left of the center groove 98a at predetermined intervals from the center groove 98a. In the solar cell module 10, the center groove 98a and the terminal box 14 are located on the substantially same line, so that the cables 16, 18 pulled out from the terminal box 14 are pulled from the space 96 through the center groove 98a to an outside of the ridge side. The side grooves 98b, 98b are used for wiring with the other solar cell modules 10 arranged in the upper row and the lower row.

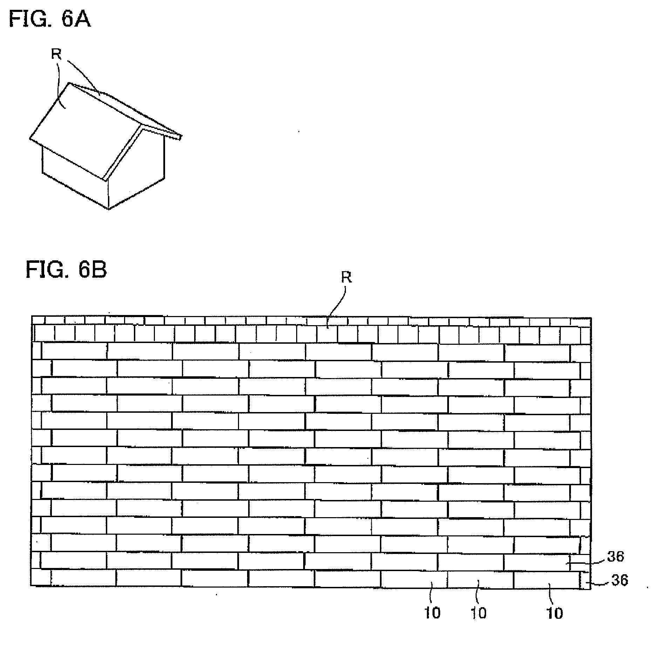

Now, the solar cell array 1 constructed by the above-mentioned solar cell modules 10 will be described in detail, making reference to a work procedure of arrangement on the roof R of the house shown in Fig. 6. For arrangement of the solar cell modules 10, a drip at the eaves and a predetermined roofing member are firstly attached to the roof R of the house on which the modules 10 are arranged. At the step 1, markings indicating lines, shapes, and sizes on the roof R required to proceed with the work are carried out. At the next step 2, counter-battens are mounted at predetermined intervals. At the step 3, tilting fillets (eaves boards) and battens (gauge laths) are mounted. The battens are mounted at predetermined intervals toward the ridge. At the step 4, fixtures for preventing blow-off of the solar cell modules 10 are mounted on predetermined positions, and then the procedure proceeds to the step 5.

At the step 5, the solar cell modules 10 are sequentially arranged from the eaves side to the ridge side of the roof R with the adjacent solar cell modules 10, 10 connected by the first and the second cables 16, 18. More specifically, the modules 10 are arranged, as shown in Figs. 6A and 6B, in such a manner that the shorter edges of a plurality of modules 10 are put together side by side with each other in a row so as to form a module row 36 and that the modules 10 are fixed to the roof R by means such as screws. In this embodiment, even number of the module rows 36 (fourteen rows 36 in Fig. 6B) are arranged on the roof R.

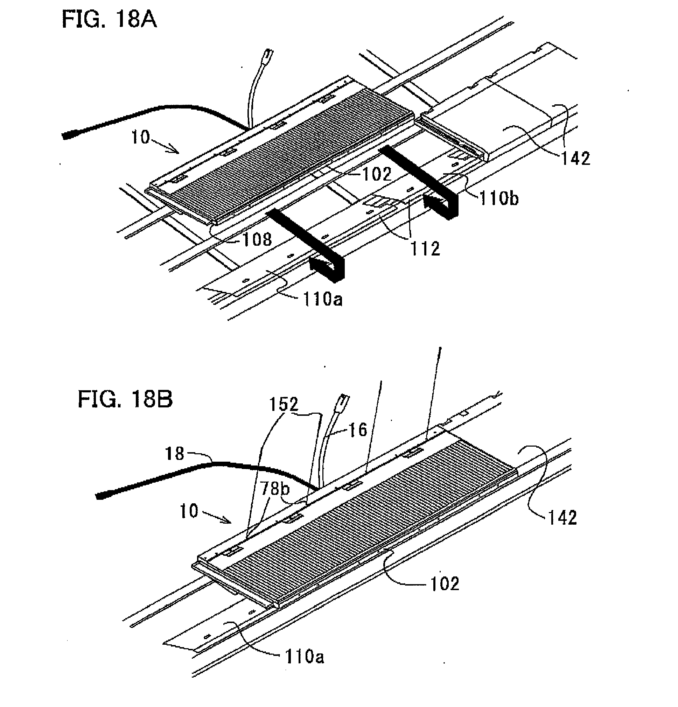

Specifically, after engagement of the modules 10 with the fixtures 110 for preventing blow-off of the modules 10, the modules 10, as shown in Fig. 18B, are fixed to the house by driving construction screws 152 into the throughholes 78b of the overlapping portion 78. At this time, the cables 16, 18 of the modules 10 are pulled out toward the ridge side.

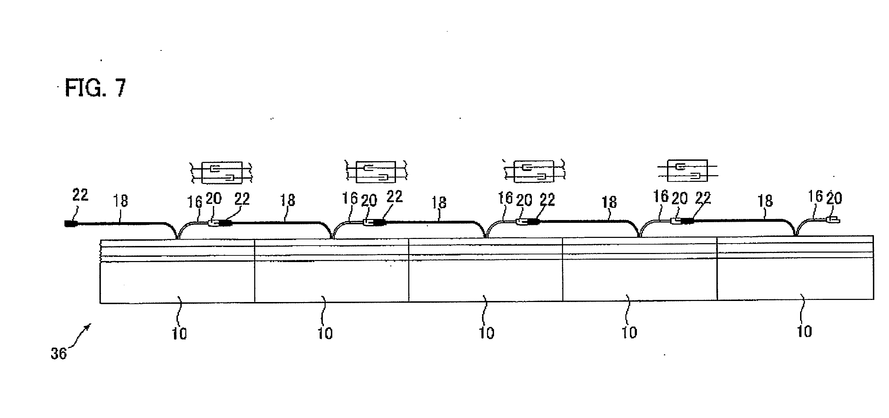

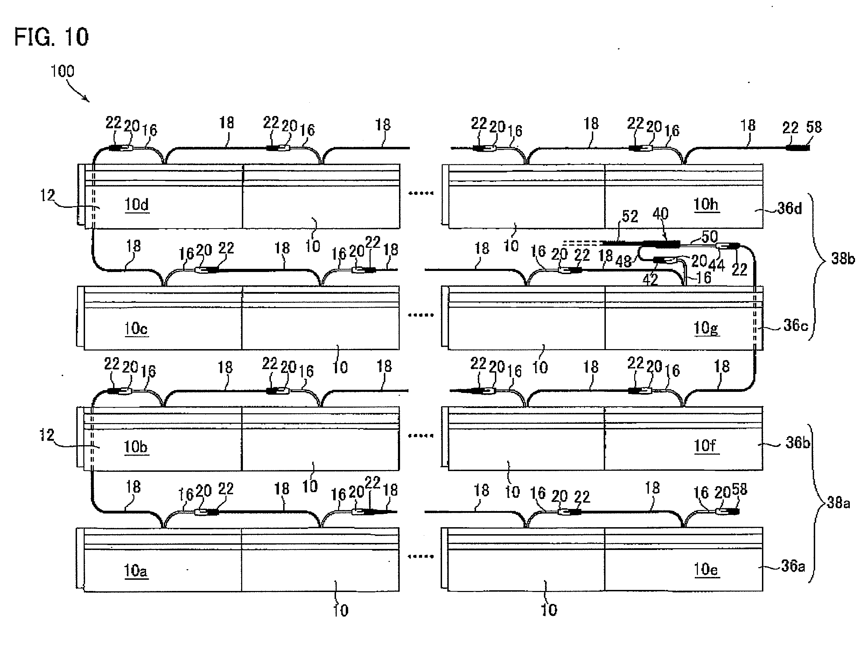

As shown in Fig. 7, during formation of the module row 36, the first connector 20 of one of the adjacent modules 10, 10 is connected to the second connector 22 of the other of the adjacent modules 10, 10, and whereby the adjacent modules 10, 10 are electrically connected in parallel. Specifically, connection of the first connector 20 in white attached to the first cable 16 in white to the second connector 22 in black attached to the second cable 18 in black allows parallel connection of the adjacent modules 10, 10. Therefore, in the modules 10 in this embodiment, connection of the adjacent modules 10, 10 on the right and left hands by the first and the second cables 16, 18 enables sequential parallel connection of all the modules 10 belonging to the module row 36 (Fig. 10).

Herein, in the module 10 in this embodiment, the first cable 16 is shorter than the second cable 18 as described above. Therefore, according to the module 10, workers immediately determine whether the connector attached to the cable 16, 18 is the first connector 20 or the second connector 22 by confirming a length of said cable.

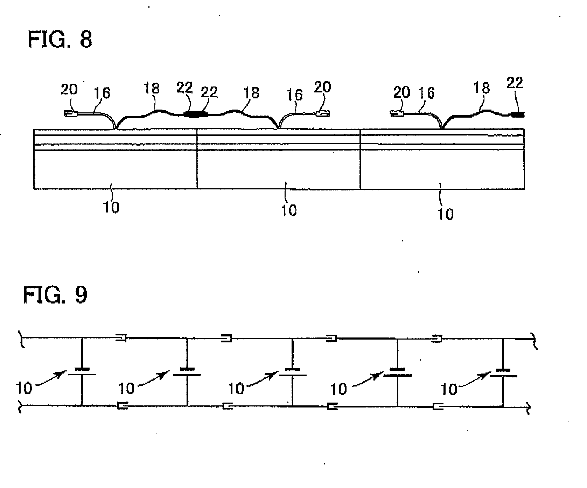

In the module 10 in this embodiment, the first cable 16 has the total length of less than 50 % of the length of the longer edges of the rectangular panel 12, while the second cable 18 has the total length of 50 % or more of the length of the longer edges of the panel 12. Therefore, as shown in Fig. 8, the first connectors 20, 20 of the respective first cables 16, 16 of the adjacent modules 10, 10 with their shorter edges adjacently put together are unconnectable to each other. Consequently, the solar cell module 10 of this embodiment surely prevents improper connection of the first connectors 20, 20 of the adjacent modules 10, 10.

The module 10 in this embodiment makes the first cable 16 white and the second cable 18 black. Therefore, workers easily determine the kinds of the connectors 20, 22 attached to the cables 16, 18 by confirming colors of the cables 16, 18.

The module 10 makes the first convector 20 white and the second connector 22 black. That is, the first connector 20 and the second connector 22 are different in color from each other. Therefore, in the module 10 in this embodiment, workers rapidly determine the kinds of the connectors 20, 22 by confirming colors of the connectors 20 and 22. Consequently, the solar cell module 10 in this embodiment allows workers rapid and appropriate selection of a connector and reduces improper wiring, thereby giving high working efficiency.

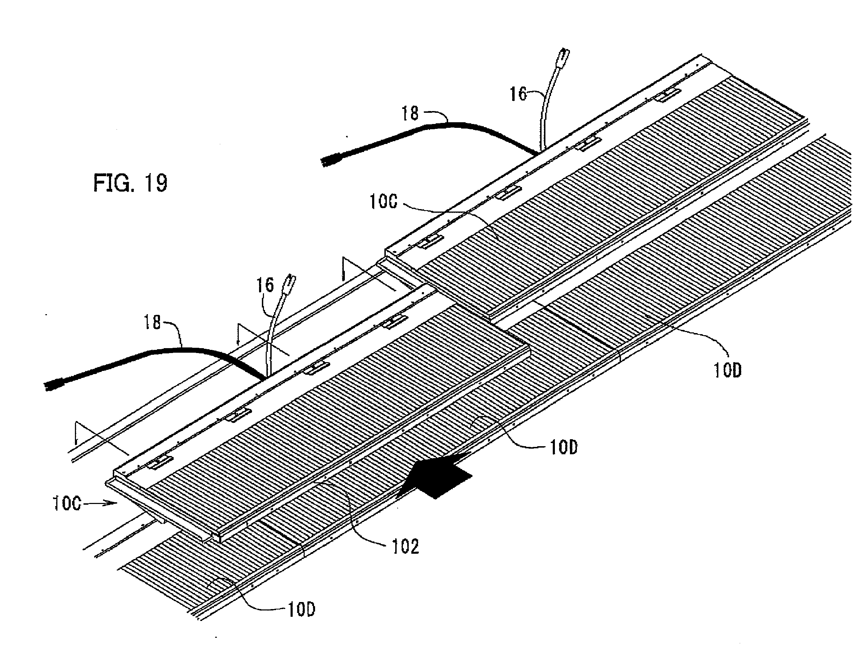

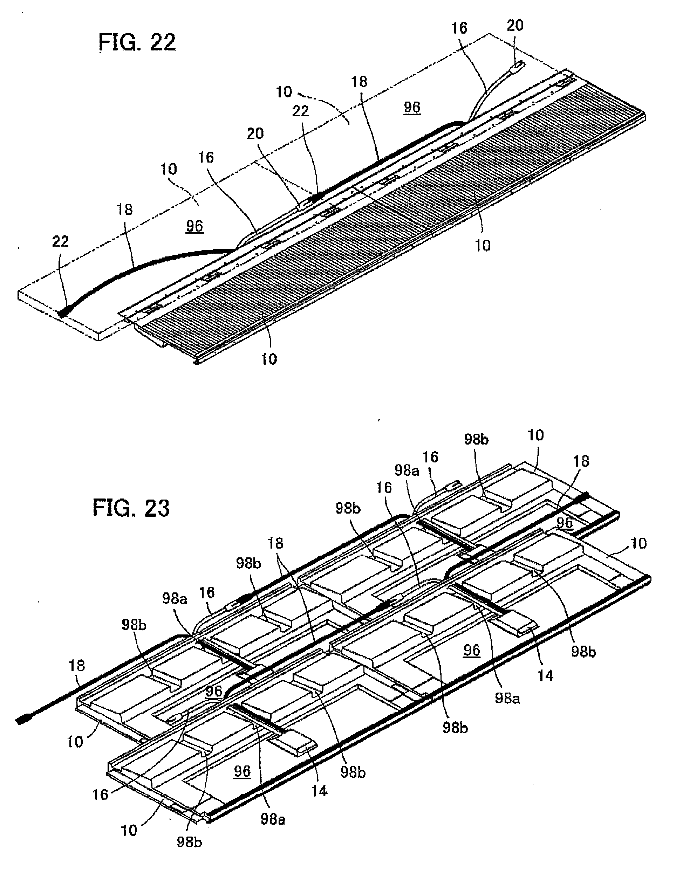

Further, in the module 10, the first cable 16 and the second cable 18 each are pulled out from a center part of the ridge side of the module 10 as shown in Fig. 1A, so as to be connected to each other with the module 10 fixed to the roof. That is, even when the module 10 is fixed to the roof by means such as nails, the first cable 16 and the second cable 18 are, as shown in Figs. 19 and 22, located outside of the main body of the module 10. Consequently, in this embodiment, the connection of the cables 16, 18 can be carried out after fixation of the module 10 to the roof by means such as nails.
The connection of the cables 16, 18 is carried out one row by one row. In this embodiment, the modules 10 are arranged from the eaves side and thus, all the modules 10 belonging to one row (first row) are firstly arranged at the eaves or near the eaves. Then, the cables 16, 18 pulled out toward the ridge side of the modules 10 are sequentially connected. The connection in one row is carried out adjacent to an upper row of the modules 10 having been arranged in the row in question. The connected cables 16, 18 are placed, as shown in Fig. 22, adjacent to the upper row of the modules 10 having been arranged in the row in question.
Subsequently, the modules 10 in the second row are fixed. Herein, the modules 10 in the second row are arranged so that the eaves sides of the modules 10 are placed on the overlapping portions 78 of the modules 10 in the first row. Therefore, the modules 10 in the second row overlap, as shown in Fig. 22, on the cables 16, 18 of the modules 10 in the first row, the cables 16, 18 in the first row being housed in the spaces 96 of the modules. 10 in the second row.

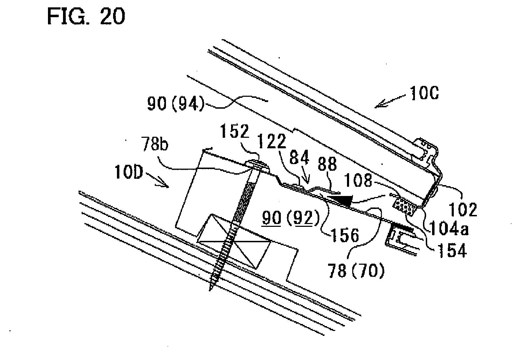

The modules 10 in the module rows 36 that follow the first row are arranged in the following way as shown in Figs. 19 and 20. The front covers 102 of the modules 10C to be arranged in an upper row are arranged on the eaves side with stoppers 108 of the covers 102 inserted into gaps 156 between the engaging portion 88 of the hooking brackets 84 and the surface of the overlapping portions 78 of the bases 70 of the modules 10D. The modules 10C are pulled up overall toward the ridge side, so as to be engaged with the modules 10D. Herein, the stopper 108 of the module 10C is provided with a seal 154, which is arranged without space in the gap 156 when the stopper 108 is inserted into the gap 156 between the engaging portion 88 of the hooking bracket 84 and the base member 70. That avoids slip at an engaged portion of the module 10C and the module 10D.

When the modules 10C are arranged at predetermined positions by engagement of the modules 10C with the modules 10D, the cables 16, 18 of the modules 10D in the lower row are orderly housed in the spaces 96 in the modules 10D in the upper row (Fig. 23).

After engagement of the stoppers 108 of the modules 10C in the upper row with the hooking brackets 84 of the modules 10D in the lower row respectively, the modules 10C in the upper row are fixed to the house by driving the screws 152 in the throughholes 78b of the overlapping portion 78 with the cables 16, 18 pulled out to the ridge side. Also as for the module rows 36 that follow the first row arranged in this way, all the modules 10 belonging to the module row 36 are connected in parallel by connecting the adjacent modules 10, 10 on the right and left hands by the cables 16, 18 in the same procedure as in the module row 36 in the first row.

As shown in Fig. 10, in the solar cell array 1 formed by a number of solar cell modules 10, connection orders of the first and second cables 16, 18 of the module rows 36a, 36c in the odd-numbered rows from the eaves side (from the bottom) and those of the module rows 36b, 36d in the even-numbered rows therefrom are different in direction. Specifically, in the module rows 36a, 36c in the odd-numbered rows, the second connector 22 in the right module 10 and the first connector 20 in the left module 10 are connected, so as to connect the second cable 18 and the first cable 16. In contrast, in the module rows 36b, 36d in the even-numbered rows, the first connector 20 in the right module 10 and the second connector 22 in the left module 10 are connected, so as to connect the first cable 16 and the second cable 18.

When all the modules 10 constituting the module row 36 are connected by the first and the second cables 16, 18, as shown in Fig. 7, among the modules 10, 10 arranged at either side of a plurality of modules 10 constituting the module row 36, the first connector 20 of the module 10 situated at one end and the second connector 22 of the module 10 situated at the other end are unused (unconnected). These unused first and second connectors 20 and 22 are used for an electrical connection of the module rows 36, 36 arranged in an upper and lower rows.

In the array 1 shown in Fig. 10, for example, the module rows 36a, 36c in the odd-numbered rows and the module rows 36b, 36d in the even-numbered rows are connected respectively, so as to form solar cell blocks 38a, 38b (hereinafter also referred to as cell blocks 38a, 38b). Specifically, the second cables 18 of the modules 10a, 10c arranged at the left ends of the module rows 36a, 36c in the odd-numbered rows pass through the respective backs of the solar cell panels 12 of the modules 10b, 10d arranged at the left ends of the module rows 36b, 36d in the even-numbered rows, so as to connect the second connectors 22 of the modules 10a, 10c to the respective first connectors 20 of the modules 10b, 10d.

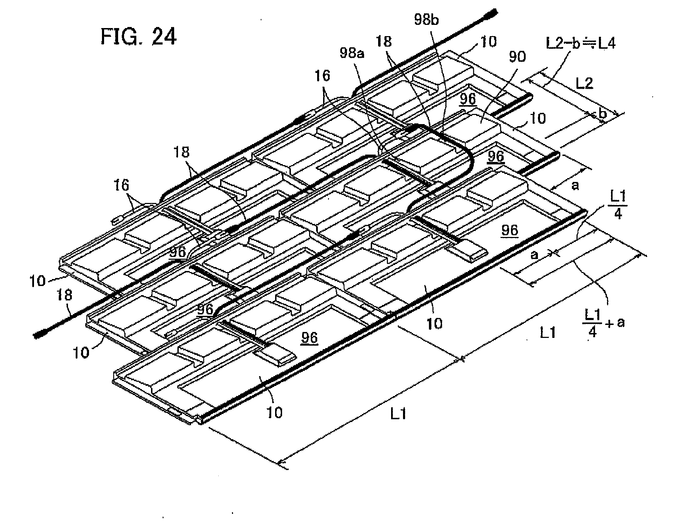

As described above, in order to connect the second cables 18 of the modules 10a, 10c in the lower rows to the respective first cables 16 of the modules 10b, 10d in the upper rows, the second cables 18 in the lower rows pass through the respective backs of the panels 12. At this time, each of the second cables 18, as shown in Figs. 23 and 24, passes through either of the side grooves 98b, 98b via the space 96 of the module 10b, 10d. Then, a distal end of the second cable 18 is pulled out further upwardly than the modules 10b, 10d in the upper row, so as to be connected to the first cable 16 of the module 10b, 10d in the upper row.

In this embodiment, in a case where the modules 10 constituting the solar cell block 38 are arranged in a plurality rows, the longer cables (second cables 18) among the two cables 16, 18 connect the modules 10 in parallel.

Herein, in the module 10 in this embodiment, if the length X of the long cable (second cable 18) is longer than the length L4 of the shorter edges of the panel 12, the second cable 18 passes under and comes further above the module 10 belonging to the module row 36 in the upper row.
In view of margin for connection, if the length X of the long cable (second cable 18) is longer than the length L2 of the shorter edges of the module 10, the second cable 18 passes under and comes further above the module 10 belonging to the module row 36 in the upper row, so as to be easily connected to the other cable.
Practically, as shown in Fig. 22, the length X of the second cable 18 is necessarily to be made longer to some extent than the length L2 of the shorter edges of the module 10 because the space through which the cable 18 is inserted is confined and the modules 10 are arranged in a staggered manner.
In the configuration shown in Fig. 22, the cable 18 passes under the module 10 via the side groove 98b in the heat insulator 90. The solar cell modules 10 belonging to the adjacent row are arranged with a shift by a length (a).
A portion overlapped with the overlapping portion 78 of the module 10 in the upper row has a length (b).
To describe by an example shown in Fig. 22, the second cable 18 has a length extended in a horizontal direction of ((L1/4) + (a)) and a length required in a vertical direction of (L2 - (b)).
Therefore, the second cable 18 needs a length of ((L1/4) + (a)) + (L2 - (b)).
In this embodiment, the length (L2 - (b)) substantially equals to the length L4 of the shorter edges of the panel 12. Consequently, the second cable 18 needs a length (((L1/4) + (a)) + L4).

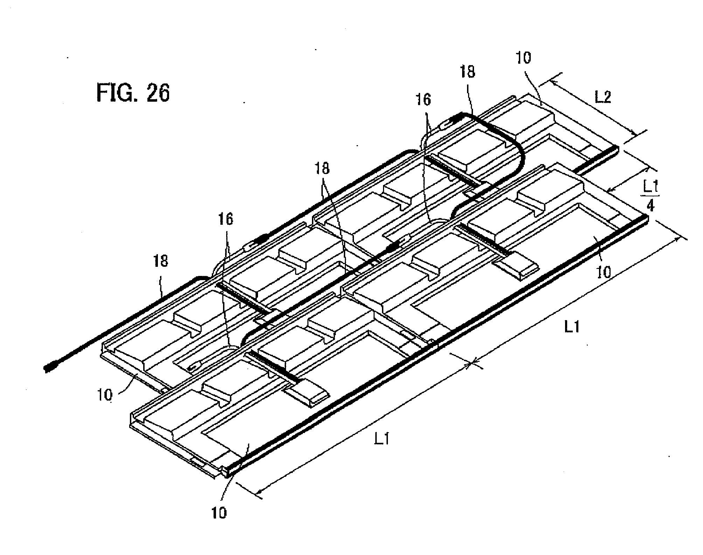

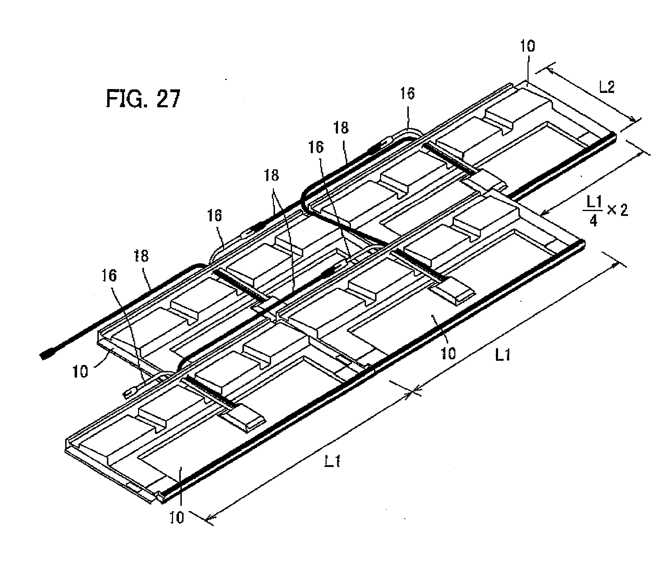

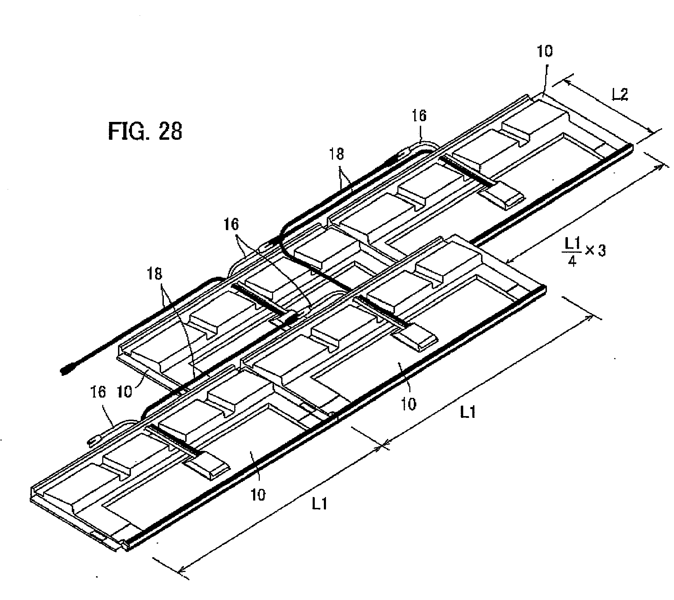

Figs. 26 to 28 each show an illustration of a considerable length of the cable 18 required by changing a shift length of the modules 10 belonging to adjacent rows. By Figs. 26 to 28, the more the shift length (a) is, the longer the cable 18 is required. When the shift length becomes three quarters of the total length L1 of the panel 12, the cable 18 is required to be longest, the length being a sum of ((L1/4) x 3) and L4. In consideration of the margin of connection, it is a sum of ((L1/4) x 3) and L2.
Consequently, the length of the cable 18 is less than or equal to a sum of ((L1/4) x 3) and L4 and preferably less than or equal to a sum of ((L1/4) x 3) and L2 in consideration of the margin.

The pulled-out length Y of the first cable 16 is shorter than the length X of the second cable 18 and shorter than a length (L1/2).
Further, the length Y is shorter than the length L4 of the shorter edges of the panel 12. Thus, the first cable 16 is prevented from passing under the module 10 in the upper row, so as to have no possibility of improper connection.
When the length Y is shorter than the length L2 of the shorter edges of the module 10, there is no possibility of improper connection because a margin for connection is practically needed.

The connection of the two cables 16, 18, in a case where the modules 10 constituting the solar cell block 38 are arranged in a plurality rows, is also carried out at outside of the modules 10. That achieves high workability. The connected cables 16, 18 are housed in the spaces 96 of the modules 10 in the next row but one as shown in Fig. 24.

Thereby, all the modules 10 belonging to the module rows 36a and 36b are connected in parallel, so as to form the cell block 38a. All the modules 10 belonging to the module rows 36c and 36d are also connected in parallel, so as to form the cell block 38b. The cell blocks 38a, 38b each are made up of twenty or more of the modules 10 electrically connected in parallel. Further, the cell blocks 38a, 38b are made up of the same number of the modules 10. The cell blocks 38a, 38b having been formed as described above are electrically connected in series by a service cable 40, and whereby the solar cell array 1 is constructed.

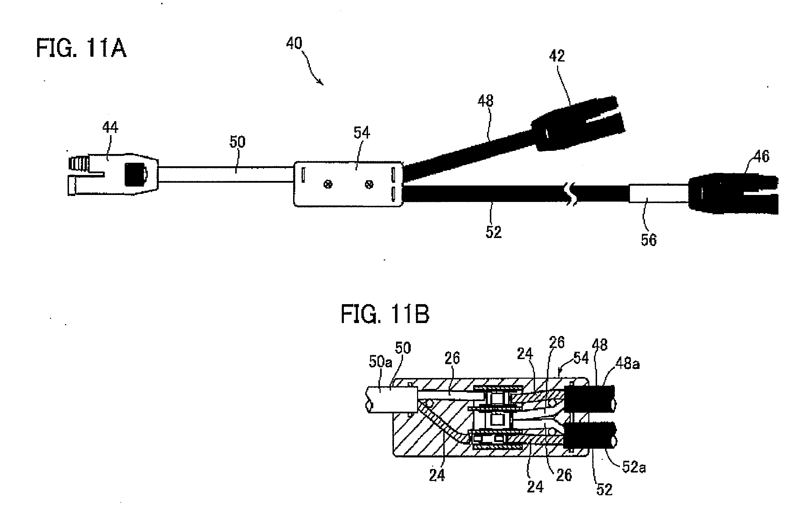

As shown in Fig. 11A, the service cable 40 consists mainly of a first serial connector 42, a second serial connector 44, an output connector 46, a first outdoor cable 48, a second outdoor cable 50, an indoor cable 52, and a molded portion 54. The first serial connector 42 is to be connected to the first connector 20 of the module 10. The second serial connector 44 is to be connected to the second connector 22 of the module 10. The output connector 46 is to be connected to an indoor power conductor (not shown) so as to output electric power converted in the panel 12 of the module 10. The first outdoor cable 48 is to be connected to the first serial connector 42. The second outdoor cable 50 is to be connected to the second serial connector 44. The indoor cable 52 is to be connected to the output connector 46.

The first serial connector 42, the second serial connector 44, and the output connector 46 have the same configuration as the fist connector 20 and the second connector 22 of the module 10. The first serial connector 42 and the output connector 46 are black, while the second serial connector 44 is white.

The first outdoor cable 48, the second outdoor cable 50, and the indoor cable 52 each have one positive inner wire 24 and one negative inner wire 26 in respective insulation tubes 48a, 50a, 52a as well as the first cable 16 and the second cable 18 of the module 10. The insulation tubes 48a, 52a of the first outdoor cable 48 and the indoor cable 52 are black, while the insulation tube 50a of the second outdoor cable 50 is white.
A white vinyl tape 56 is wound around a part adjacent to the output connector 46 of the indoor cable 52, thereby enabling immediate determination of the indoor cable 52 and the output connector 46.

As shown in Fig. 11B, the first outdoor cable 48, the second outdoor cable 50, and the indoor cable 52 are connected within the molded portion 54. To put it more specifically, the positive inner wire 24 of the first outdoor cable 48 is electrically connected to the negative inner wire 26 of the second outdoor cable 50, while the negative inner wire 26 of the first outdoor cable 48 is electrically connected to the negative inner wire 26 of the indoor cable 52, and while the positive inner wire 24 of the second outdoor cable 50 is electrically connected to the positive inner wire 24 of the indoor cable 52.

As shown in Fig. 10, when the cell block 38a and the cell block 38b are connected in series by the service cable 40, the second serial connector 44 (white) of the service cable 40 is connected to the second connector 22 (black) of the rightmost solar cell module 10f in the module row 36b constituting the cell block 38a. Meanwhile, the first serial connector 42 (black) of the service cable 40 is connected to the first connector 20 (white) of the rightmost solar cell module 10g in the module row 36c constituting the cell block 38b.

In short, the connections of the service cable 40 to the cell blocks 38a, 38b are done only by connecting the connectors being different in color as well as the connection of the adjacent modules 10, 10. That reduces improper connection of wiring. Further, as described above, the service cable 40 is connected to the cell blocks 38a, 38b only by the connections of predetermined combinations between the connectors 44, 22, 42, 20. That allows easy working on the roof R.

Herein, the cell blocks 38a, 38b in this embodiment are constituted by a plurality of the solar cell modules 10, one module generating a voltage of about 100 volts, connected in parallel. The cell blocks 38a, 38b also generate a voltage of about 100 volts in total. The solar cell array 1 is constituted by the two cell blocks 38a, 38b serially connected by the service cable 40, thereby outputting a voltage of about 200 volts, which is a rated voltage of various devices.

As described above, the solar cell modules 10 defined in this application are connected by the first cables 16 and the second cables 18 and further a plurality of the modules 10 connected in parallel constitute the solar cell blocks 38a, 38b, which are connected in series by the service cable 40. The above-mentioned work is easy and simple without improver wiring, thereby arranging a number of modules 10 on the roof. And an output voltage of substantially 200 volts is obtained from the output cable 52 of the service cable 40.
Therefore, according to this invention, a wiring work can be done by anyone even if being not a skilled electrician. For example, skilled workers in high places such as a roof tiler and a carpenter can easily finish a wiring work.
Further, the way such as increasing of the number of unit solar cells 100 of the solar cell panel 12 of the solar cell module 10 can generate a voltage of 200 volts or more. For example, it is possible to generate a voltage of 200 volts to 360 volts.

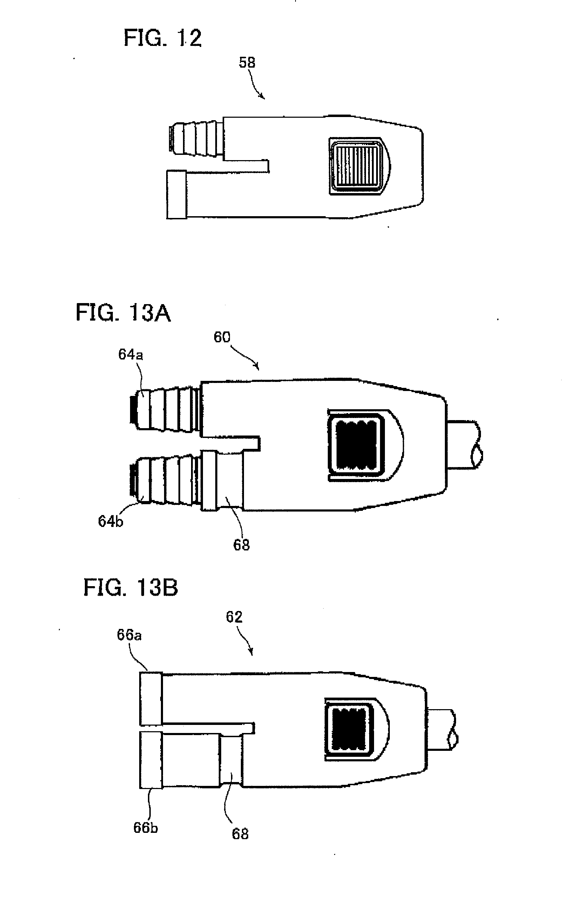

As shown in Fig. 10, the first connector 20 of the rightmost module 10e in the module row 36a and the second connector 22 of the rightmost module 10h in the module row 36d are unused (unconnected) with the cell blocks 38a, 38b serially connected. According to the array 1 of the modules 10 in this embodiment, the first and second connectors 20, 22 each are attached with the terminal protector 58 shown in Fig. 12. The terminal protector 58 has the substantially same configuration with the first connector 20 and the second connector 22 of the module 10 except that no cable is connected. In the array 1 of the modules 10 in this embodiment, the terminal protectors 58 attached to the unused connectors 20, 22 protect the terminals 28, 30 of the unused first and second connectors 20, 22 from adhering of dust or water.

When the arrangement work of the array 1 of the modules 10 carried out as described above is interrupted, the terminals 28, 30 of the connectors 20, 22 are protected from adhering of dust or water by attaching the terminal protectors 58 to the unconnected first or second connector 20 or 22.

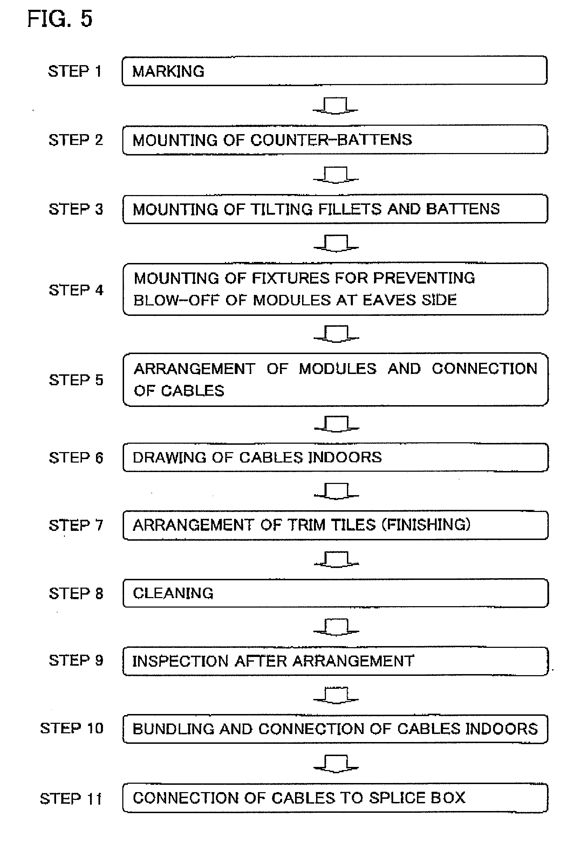

After completion of the work in the step 5 in Fig. 5 as described above, workers pull the indoor cable 52 of the service cable 40 within the house at the step 6. Thereafter, trim tiles are arranged (step 7), the roof R is cleaned (step 8), an inspection is given (step 9), the service cables 40 are banded in the house (step 10), and then the output connector 46 is connected to a splice box (not shown) of the power conductor (step 11). Thus, a series of procedure is completed.

As described above, the solar cell module 10 in this embodiment includes the solar cell panel 12, the panel 12 having the length L1 of its longer edges of 900 to 1100 mm and the module 10 having the length L2 of its shorter edges of 240 to 480 mm.
More specifically, the solar cell module 10 has a whole length WL of its longer edges of 920 to 1200 mm and the length L2 of its shorter edges of 240 to 480 mm, while the solar cell panel 12 has the length L1 of its longer edges of 900 to 1100 mm and the length L4 of its shorter edges of 230 to 320 mm.
By this configuration, the modules 10 are easily carried in and arranged at a place such as a roof of a house, where the arrangement work is difficult. Further, the module 10 in this embodiment has the length of its longer edges being about twice a size of a common roof tile and the length of its shorter edges being substantially the same as that. Thus, the modules 10 described above are arranged by the similar working method as common tiling arranged sequentially in a horizontal direction by orienting those on a roof so that they are wider than they are tall (elongated in the ridge direction), thus being suitable to arrangement on a roof.

As described above, the cell panels 12 each are formed by lining up a plurality of the strip-like unit cells 100 having the width of 7 to 12 mm and electrically connecting those in series, thereby ensuring the uniform configuration. Further, being formed in this way, the cell panels 12 have little individual difference in output power. Therefore, the solar cell array 1 constructed as described above minimizes power reduction of the entire array 1 caused by the individual difference in output power of the cell panels 12.

As described above, the unit cells 100 constituting the cell panel 12 each have the width of 7 to 12 mm and the open-circuit voltage of 1.2 to 1.5 volts. Therefore, the cell panel 12 and the module 10 having the above-mentioned sizes generate an output voltage suitable to construct the solar cell array 1.

The above-mentioned unit cell 100 is of a tandem type formed by lamination of the photoelectric conversion units 106a, 106b, thereby utilizing energy contained in incident light to the maximum. The above-mentioned embodiment illustrates an example employing the unit cell 100 of the two-layered tandem type (hybrid) with the laminated units 106a, 106b, but the present invention is not limited thereto and may be that of an n-layered tandem type (n = an integer more than two). Further, the unit cell 100 is not limited to be of the tandem type and may be of a type of a single layer having either one of the units 106a, 106b.

The above-mentioned embodiment illustrates an example employing the solar cell panel 12 capable of outputting the short-circuit current in a range of 9 to 15 mA/cm², but the present invention is not limited thereto and may be that capable of outputting the short-circuit current beyond the above-mentioned range.

As described above, in the above-mentioned embodiment, the cell blocks 38a, 38b each are configured by twenty or more of the modules 10 electrically connected in parallel, so as to have a small effect on power reduction of the entire array 1 even with power reduction of a part of the modules 10. Thus, the above-mentioned array 1 achieves stable output performances with less effect by power reduction of a part of the modules 10 even if the power reduction would happen. The abode-mentioned embodiment illustrates an example in which the cell blocks 38a, 38b each are configured by connecting twenty or more of the modules 10 in parallel, but the present invention is not limited thereto and may have the cell blocks 38a, 38b each configured by less than twenty modules 10.

The solar cell array 1 described above is formed by connecting the two cell blocks 38 in series, but the present invention is not limited thereto and may be formed by constructing more than two cell blocks 38 and connecting those in series.

The module 10 described above dispenses with a dividing line dividing an area of the unit cell 100 that generates electricity (effective electricity-generating area) upon reception of light into sections electrically insulated from each other, but the present invention is not limited thereto and may have a configuration with at least one dividing line 118, as shown in Fig. 14, extending in the longer-edge direction of the module 10. By this configuration, even if a part of a specific unit cell 100 would fail to generate electricity because of being in shade, the module 10 is protected from deterioration or breaking due to a hot spot phenomenon. Further, provision of the dividing line 118 prevents generation of individual difference in output performances of the modules 10 due to a hot spot phenomenon and an imbalance of output of the cell blocks 38a, 38b resulting from the individual difference after arrangement of the array 1, thereby utilizing output power generated by the normally-operating modules 10 to the maximum.

The divining line 118 may be formed so as to pass through any position in the unit cell 100, but is preferably formed at an upper end portion (ridge side) of the module 10 and/or at a lower end portion (eaves side), that is, at a position eccentrically located toward the upper end and/or the lower end in the shorter-edge direction of the module 10, when the modules 10 are arranged on a house. This configuration prevents a hot spot phenomenon at a ridge-side portion hidden behind another module 10 or a roof tile arranged above and an eaves-side portion easily collecting dust and trash.

Further, the solar cell modules 10 in this embodiment are arranged with the cables 16, 18 pulled toward the ridge side. Thus, as well as the general manner to tile a house, the modules 10 are readily arranged from the eaves side to the ridge side of a house. Consequently, even workers being inexperienced in electric work for example readily and orderly wire the cables 16, 18 and arrange the modules 10.

Further, the array 100 in this embodiment employs the above-mentioned solar cell modules 10, thereby facilitating wiring of the cables 16, 18 in arrangement and reducing the possibility of breaking of wire caused by twisting of the cables 16, 18 or the like. Still further, the array 100 in this embodiment are arranged with the cables 16, 18 of the module 10 pulled toward the ridge side without especial wiring of the cables 16, 17. Therefore, as well as the general manner to tile a house, the array 100 in this embodiment facilitates works such as connection of the cables 16, 18 by arranging the modules 10 from the eaves side to the ridge side of a house.

In the solar cell modules 10 in this embodiment the accommodation space 96 formed on the base 82 is enclosed by the ridge-direction reinforcing portion 92 and the inclining-direction reinforcing portions 94, 94 of the reinforcing heat insulator 90 on three sides. Therefore, the space 96 keeps out air and water from its upper side (ridge side) or its right and left sides when the modules 10 are arranged on a house, so that the terminal box 14 is protected from being wet.

In the solar cell module 10 in this embodiment, the accommodation space 96 is open toward an eaves-side edge 162, so as to be ventilated through the opened part. Therefore, even if the terminal box 14 is subjected to high temperature resulting from power distribution, heat is prevented from accumulating in the space 96, so that a suitable temperature condition is maintained in the space 96.

The solar cell module 10 in this embodiment, as shown in Fig. 2, has a gap 168 around the terminal box 14 in the space 96. That surely prevents heat generated in the terminal box 14 from accumulating in the space 96 and a trouble, such as failure and break of the terminal box 14 caused by the heat, from occurring.

In the solar cell module 10 in this embodiment, the ridge-direction reinforcing portion 92 of the reinforcing heat insulator 90 is made of formed resin. That protects the cables 16, 18 from being subjected to an excess load even if the cables 16, 18 fail to pass through the cable grooves 98 formed in the portion 92 and happen to get stuck in between a top surface of a house and the portion 92. Consequently, the solar cell module 10 surely avoids inconvenience such as breaking of the cables 16, 18.

### EXAMPLES

Now, examples of the present invention will be described in detail below.
Fig. 1A is a perspective view of the roof-tile shaped solar cell module employed in the embodiment of the present invention. Fig. 4 is a cross section of the connector of the solar cell module shown in Fig. 1.

The roof-tile shaped solar cell module 10 is an integrated solar cell, in which a plurality of unit solar cells are formed so as to constitute a solar cell as a whole.
Specifically, the module 10 is formed by laminating a film such as a conducting film and a semiconductor film on a glass substrate, cutting a plurality of grooves on the laminated layer so that the layer is divided into a number of one-cell batteries (unit solar cells), and electrically connecting the unit solar cells in series.

The module 10 is of a rectangular shape as shown in figures with the two cables 15, 18 pulled out from a center part of its longer edge.
Further, the cables 16, 18 are connected to the connectors 20, 22 respectively.
The cables 16, 18 are different in length, one being long and one being short. Specifically, the long cable 18 has a total length of 50 % or more of a total length of the module 10, while the short cable 16 has a total length of less than 50 % of the total length of the module 10.
Further, the cables 16, 18 are different in color. The cables 16, 18 each have two electrically-insulated conducting wires 24, 26 (the positive inner wire 24 and the negative inner wire 26). More specifically, the cables 16, 18 each are a cable with the two covered conducting wires 24, 26 arranged in one insulation tube.

The cables 16, 18 are connected to the connectors 20, 22 respectively. The connectors 20, 22 are different in color but have the same configuration in which the two terminals 28, 30 (the pin terminal 28 and the socket terminal 30) are provided as shown in Fig. 4.
The pin terminal 28 is of a pin shape and the socket terminal 30 is of a socket shape.
Further, the connectors 20, 22 each have the female portion 32 and the male portion 34, the pin terminal 28 being formed in the female portion 32 and the socket terminal 30 being formed in the male portion 34.
The connectors 20, 22 are connectable to each other with the female portion 32 of one of the connectors 20, 22 and the male portion 34 of the other thereof connected. When one pair of the female portion 32 and the male portion 34 is connected, the pin terminal 28 of the female portion 32 and the socket terminal 30 of the male portion 34 are connected inside the portions.

In this embodiment, the two covered conducting wires 24, 26 of each of the two cables 16, 18 are connected to the positive electrode and the negative electrode of the solar cell in the module 10 respectively. Specifically, the coated conducting wire 24 in the cable 18 is connected to the positive electrode of the solar cell, while the coated conducting wire 26 therein is connected to the negative electrode of the solar cell. Similarly, the coated conducting wire 24 in the cable 16 is connected to the positive electrode of the solar cell, while the coated conducting wire 26 therein is connected to the negative electrode of the solar cell.
Consequently, one of the two terminals 28, 30 of the connector 22 is connected to the positive electrode of the solar cell, while the other thereof is connected to the negative electrode of the solar cell. Similarly, one of the terminal 28, 30 of the connector 20 is connected to the positive electrode of the solar cell, while the other thereof is connected to the negative electrode of the solar cell.
Herein, the two terminals 28, 30 of the connectors 20, 22 have reverse polarities. Specifically, in the connector 20, the pin terminal 28 has the positive electrode and the socket terminal 30 has the negative electrode. In contrast, in the connector 22, the pin terminal 28 has the negative electrode and the socket terminal 30 has the positive electrode.

Now, an arrangement structure of the roof-tile shaped solar cell module 10 described above will be described in detail below.
Fig. 7 is a conceptual diagram showing the modules 10 properly connected. Fig. 8 is a conceptual diagram showing the modules 10 improperly connected. Fig. 9 is a circuit diagram of wiring in which the modules 10 are properly connected.
The above-mentioned modules 10 are, as shown in Figs. 5 and 7, are arranged on a structural subject such as a roof by lining up in one row sideways.
Then, the connectors 20, 22 of adjacent modules 10 are connected. Looking at one module 10, the connector 22 of said module 10 is connected to the connector 20 of the module 10 located to its immediate left. The connector 20 of said module 10 is connected to the connector 22 of the module 10 located to its immediate right.
To explain with focusing on the lengths of the cables, the connector 22 of the long cable 18 of said module 10 is connected to the connector 20 of the short cable 16 of the module 10 located to its immediate left. The connector 20 of the short cable 16 of said module 10 is connected to the connector 22 of the long cable 18 of the module 10 located to its immediate right.
As a result, as shown in Fig. 7, the solar cells are connected in parallel.

In contrast, because of improper connection, as shown in Fig. 8, connection of the connectors 22 of the long cables 18 renders the other connectors 20 physically unable to connect, and whereby workers notice the improper connection. That is because the connector 20 is connected to the short cable 16, which has a length less than a half of the total length of the module 10. Further, since the cables 16, 18 each are pulled out from the center part of the module 10, the short cables 16 lacks length, thus being unconnectable to each other.
Consequently, the roof-tile shaped solar cell modules 10 in this embodiment are never wired improperly.

## Claims

1. A solar cell module to be arranged on a roof of a house and to constitute a solar cell array formed by electrically connecting in series a plurality of solar cell blocks formed by electrically connecting a plurality of the solar cell modules in parallel,
the module having longer edges and shorter edges with a total length of each of the longer edges of 920 to 1200 mm and a total length of each of the shorter edges of 240 to 700 mm,
the module comprising a solar cell panel, the solar cell panel being formed in a substantially rectangular plane with longer edges and shorter edges and having a length of the longer edges of 900 to 1200 mm and a length of the shorter edges of 230 to 650 mm, and being arranged so that the longer edges of the panel extend in a ridge direction of the house and the shorter edges of the panel extend in a direction perpendicular to the ridge direction of the house,
wherein the solar cell panel comprises a plurality of unit solar cells and is formed by electrically connecting the cells in series so as to have an open-circuit voltage of 100 to 180 volts,
wherein the unit solar cells each are of a strip-like shape with longer edges and shorter edges, the shorter edges having a length of 7 to 12 mm, and are arranged in lines in a longer-edge direction of the panel so that the longer edges extend in a shorter-edge direction of the panel and the shorter edges extend in the longer-edge direction of the panel,
the module further comprising two positive conducting wires in electrical connection with a positive electrode of the solar cell panel and two negative conducting wires in electrical connection with a negative electrode of the solar cell panel,
wherein the two positive conducting wires and the two negative conducting wires each are pulled out from one of the longer edges of the module,
the module having a space for accommodating the two positive conducting wires and the two negative conducting wires of another panel in a back of the module, and
the module having an overlapping portion for overlapping a part of another module on its top face.

2. The solar cell module as defined in claim 1,
wherein the unit solar cells each have the open-circuit voltage of 1.2 to 1.5 volt.

3. The solar cell module as defined in one of claims 1 and 2,
wherein the overlapping portion is formed on a part except a top face of the solar cell panel.

4. The solar cell module as defined in any preceding claim,
wherein the unit solar cells each are of a tandem type.

5. The solar cell module as defined in any preceding claim,
wherein the solar cell panel has a short-circuit current of 9 to 15 mA/cm².

6. The solar cell module as defined in any preceding claim,
wherein the unit solar cells each have an effective electricity-generating area where electricity is generated upon reception of light, and
wherein the module has at least one dividing line extending in the longer-edge direction of the module and dividing the effective electricity-generating area of the unit solar cell.

7. The solar cell module as defined in any preceding claim,
having grooves through which a cable is inserted in the shorter-edge direction in the back of the module.

8. A solar cell array being formed by serially connecting two solar cell blocks, the solar cell blocks each being formed by electrically collecting in parallel a plurality of the solar cell modules as defined in any preceding claim.

9. The solar cell array as defined in claim 8,
wherein the solar cell blocks each are formed by electrically connecting twenty or more of the solar cell modules in parallel.

10. The solar cell array as defined in one of claims 8 and 9,
wherein a plurality of the modules are arranged in a plane in a plurality of rows each consisting of the modules,
wherein the positive conducting wire of one of adjacent modules and the negative conducting wire of the other of the adjacent modules are connected to each other with the connected conducting wires housed in the space of the module in an adjacent row.

11. The solar cell array as defined in one of claims 8 to 10,
the one positive conducting wire and the one negative conducting wire of the module located at an end of one row and the one positive conducting wire and the one negative conducting wire of the module located at an end of its adjacent row being connected to each other and housed in the space of the module of the next row but one.
